# EUROPEAN PATENT APPLICATION

(11) **EP 1 981 094 A2**
(43) Date of publication of application: **15.10.2008**
(21) Application number: 08154435.5
(22) Date of filing: 11.04.2008
(51) Int. Cl.: H01L 33/00

(54) **Semiconductor Device, Led Head and Image Forming Apparatus**

(30) Priority: 13.04.2007 JP 2007105971
(71) Applicant: Oki Data Corporation, Tokyo 108-8551 (JP)
(72) Inventor: Ogihara, Mitsuhiko, Hachioji-shi Tokyo 193-8550 (JP); Sagimori, Tomohiko, Hachioji-shi Tokyo 193-8550 (JP); Suzuki, Takahito, Hachioji-shi Tokyo 193-8550 (JP); Fujiwara, Hiroyuki, Hachioji-shi Tokyo 193-8550 (JP); Igari, Tomoki, Hachioji-shi Tokyo 193-8550 (JP); Sakuta, Masaaki, Minato-ku Tokyo 108-0023 (JP)
(74) Representative: Betten & Resch

(57) **Abstract**

A semiconductor device is supplied which is able to efficiently liberate heat produced by semiconductor element toward external, prevent temperature rise, improve operation characteristic and maintain stable operation. The semiconductor device comprises a substrate and a semiconductor thin film layer which is accumulated on the substrate and contains semiconductor element, the substrate is a metal substrate, between the metal substrate and the semiconductor thin film layer, a diamond-like carbon layer with high heat conductivity and good insulativity is furnished as a surface coating layer.

## Description

### BACKGROUND OF THE INVENTION

### Field of the Invention

The invention relates to a semiconductor device, a LED head and an image forming apparatus; in particular, relates to a semiconductor device, a LED head and an image forming apparatus that can improve characteristic and reliability through effectively diffuse heat caused from semiconductor element.

### Related Background Art

Semiconductor element produces heat when operating. Further, in the semiconductor element, region which most produces heat is operating region. For example, if the semiconductor element is a light emitting diode, a light emitting region near to PN junction or of an active layer becomes a light emitting center. Then, a temperature rise of the semiconductor element brings on a bad influence with respect to characteristic and reliability of semiconductor device. In order to eliminate the bad influence, it is important to efficiently conduct the heat energy produced by the semiconductor element toward external of the semiconductor device so as to diffuse heat. With respect to such project, many related technology are disclosed. For example, in patent document 1, the light emitting diode formed on a substrate such as a sapphire substrate or the like is stuck onto a diamond substrate which is an insulator and has so high heat conductivity, so as to efficiently conduct the heat energy toward external of the semiconductor device.
Patent document 1: Japan patent publication 2002-329896.

However, in the above-stated technology, a problem exists, that is, because the sapphire substrate intervenes between a light emitting region and the diamond substrate, a distance between a main heat producing region and material with high heat conductivity becomes far, so that an effect to diffuse heat is dropped.

### SUMMARY OF THE INVENTION

It is, therefore, an object of the invention to provide a semiconductor device, a manufacturing method of the semiconductor device, a LED head and an image forming apparatus that can solve the above-mentioned problem.

According to the present invention, there is provided a semiconductor device, which comprises a substrate; a semiconductor thin film layer that is accumulated on the substrate and contains semiconductor element; and a diamond-like carbon layer that is furnished between the substrate and the semiconductor thin film layer.

Moreover, in the semiconductor device, the substrate may be a freestanding diamond-like carbon substrate.

Moreover, in the semiconductor device, the substrate may be a freestanding SiC substrate.

Further, according to the present invention, there is provided a LED head, which comprises the semiconductor device of the present invention.

Furthermore, according to the present invention, there is provided an image forming apparatus, which comprises the LED head of the present invention.

### Effect of the present invention

According to the present invention, because only a thin diamond-like carbon layer is furnished between a substrate and a semiconductor thin film layer so as to shorten a distance between a active layer and the substrate, a heat conduction from the active layer which is a main heat producing region to the substrate whose heat conductivity is high becomes high efficient. Here, because the diamond-like carbon layer is thin, it is impossible that the efficiency of heat conduction in a thickness direction drops. As a result, it is possible to efficiently diffuse the heat produced by the semiconductor element toward the external, and prevent the temperature of the semiconductor device from rising. Therefore, it is possible to improve the operation characteristic of the semiconductor device and to sustain a stable operation.

The above and other objects and features of the present invention will become apparent from the following detailed description and the appended claims with reference to the accompanying drawings.

### BRIEF DSCRIPTION OF THE DRAWINGS

Fig. 1 is a cubic diagram showing a semiconductor device in embodiment 1 of the present invention;
Fig. 2 is a cross section showing a semiconductor device in embodiment 1 of the present invention;
Fig. 3 is a cross section showing a LED element in embodiment 1 of the present invention;
Fig. 4 is a first diagram for explaining a manufacturing method of LED element in embodiment 1 of the present invention;
Fig. 5 is a second diagram for explaining a manufacturing method of LED element in embodiment 1 of the present invention;
Fig. 6 is a third diagram for explaining a manufacturing method of LED element in embodiment 1 of the present invention;
Fig. 7 is a fourth diagram for explaining a manufacturing method of LED element in embodiment 1 of the present invention;
Fig. 8 is a fifth diagram for explaining a manufacturing method of LED element in embodiment 1 of the present invention;
Fig. 9 is a sixth diagram for explaining a manufacturing method of LED element in embodiment 1 of the present invention;
Fig. 10 is a cross section showing a LED element in another conformation [1] of embodiment 1 of the present invention;
Fig. 11 is a first diagram for explaining a manufacturing method of LED element in another conformation [1] of embodiment 1 of the present invention;
Fig. 12 is a second diagram for explaining a manufacturing method of LED element in another conformation [1] of embodiment 1 of the present invention;
Fig. 13 is a third diagram for explaining a manufacturing method of LED element in another conformation [1] of embodiment 1 of the present invention;
Fig. 14 is a fourth diagram for explaining a manufacturing method of LED element in another conformation [1] of embodiment 1 of the present invention;
Fig. 15 is a fifth diagram for explaining a manufacturing method of LED element in another conformation [1] of embodiment 1 of the present invention;
Fig. 16 is a sixth diagram for explaining a manufacturing method of LED element in another conformation [1] of embodiment 1 of the present invention;
Fig. 17 is a seventh diagram for explaining a manufacturing method of LED element in another conformation [1] of embodiment 1 of the present invention;
Fig. 18 is an eighth diagram for explaining a manufacturing method of LED element in another conformation [1] of embodiment 1 of the present invention;
Fig. 19 is a cross section showing a LED thin film layer in another conformation [2] of embodiment 1 of the present invention;
Fig. 20 is a cross section showing a LED thin film layer in another conformation [3] of embodiment 1 of the present invention;
Fig. 21 is a first diagram for explaining a manufacturing method of LED thin film layer in another conformation [2] of embodiment 1 of the present invention;
Fig. 22 is a second diagram for explaining a manufacturing method of LED thin film layer in another conformation [2] of embodiment 1 of the present invention;
Fig. 23 is a third diagram for explaining a manufacturing method of LED thin film layer in another conformation [2] of embodiment 1 of the present invention;
Fig. 24 is a first diagram for explaining a manufacturing method of LED thin film layer in another conformation [3] of embodiment 1 of the present invention;
Fig. 25 is a second diagram for explaining a manufacturing method of LED thin film layer in another conformation [3] of embodiment 1 of the present invention;
Fig. 26 is a third diagram for explaining a manufacturing method of LED thin film layer in another conformation [3] of embodiment 1 of the present invention;
Fig. 27 is a cross section showing a LED thin film layer in another conformation [4] of embodiment 1 of the present invention;
Fig. 28 is a diagram for explaining a manufacturing method of LED thin film layer in another conformation [4] of embodiment 1 of the present invention;
Fig. 29 is a cross section showing a LED thin film layer in another conformation [5] of embodiment 1 of the present invention;
Fig. 30 is a cross section showing a LED thin film layer in another conformation [6] of embodiment 1 of the present invention;
Fig. 31 is a cross section showing a LED thin film layer in another conformation [7] of embodiment 1 of the present invention;
Fig. 32 is a cross section showing a LED thin film layer in another conformation [8] of embodiment 1 of the present invention;
Fig. 33 is a cross section showing a LED thin film layer in another conformation [9] of embodiment 1 of the present invention;
Fig. 34 is a cross section showing a LED thin film layer in another conformation [10] of embodiment 1 of the present invention;
Fig. 35 is a cross section showing a LED thin film layer in another conformation [11] of embodiment 1 of the present invention;
Fig. 36 is a cross section showing a LED thin film layer in another conformation [12] of embodiment 1 of the present invention;
Fig. 37 is a cross section showing a LED thin film layer in another conformation [13] of embodiment 1 of the present invention;
Fig. 38 is a cross section showing a LED thin film layer in another conformation [14] of embodiment 1 of the present invention;
Fig. 39 is a plane diagram showing a LED device in embodiment 2 of the present invention;
Fig. 40 is a magnification diagram of A-A section in Fig. 39;
Fig. 41 is a diagram for explaining a heat conduction of LED device in embodiment 2 of the present invention;
Fig. 42 is a cross section showing a semiconductor device in embodiment 3 of the present invention;
Fig. 43 is a cross section showing a LED element in embodiment 3 of the present invention;
Fig. 44 is a cross section showing a LED element in a transformation example of embodiment 3 of the present invention;
Fig. 45 is a cross section showing a semiconductor device in embodiment 4 of the present invention;
Fig. 46 is a cross section showing a LED element in embodiment 4 of the present invention;
Fig. 47 is a cross section showing a LED element in a transformation example of embodiment 4 of the present invention;
Fig. 48 is a cross section showing a semiconductor device in embodiment 5 of the present invention;
Fig. 49 is a cross section showing a LED element in embodiment 5 of the present invention;
Fig. 50 is a cross section showing a semiconductor device in embodiment 6 of the present invention;
Fig. 51 is a cross section showing a LED element in embodiment 6 of the present invention;
Fig. 52 is a first cross section showing a semiconductor device in embodiment 7 of the present invention;
Fig. 53 is a second cross section showing a semiconductor device in embodiment 7 of the present invention;
Fig. 54 is a third cross section showing a semiconductor device in embodiment 7 of the present invention;
Fig. 55 is a fourth cross section showing a semiconductor device in embodiment 7 of the present invention;
Fig. 56 is a cubic diagram showing a light emitting element array in embodiment 8 of the present invention;
Fig. 57 is a first cubic diagram showing a transformation example of light emitting element array in embodiment 8 of the present invention;
Fig. 58 is a second cubic diagram showing a transformation example of light emitting element array in embodiment 8 of the present invention;
Fig. 59 is a third cubic diagram showing a transformation example of light emitting element array in embodiment 8 of the present invention;
Fig. 60 is a fourth cubic diagram showing a transformation example of light emitting element array in embodiment 8 of the present invention;
Fig. 61 is a fifth cubic diagram showing a transformation example of light emitting element array in embodiment 8 of the present invention;
Fig. 62 is a sixth cubic diagram showing a transformation example of light emitting element array in embodiment 8 of the present invention;
Fig. 63 is a cubic diagram showing a semiconductor device in embodiment 9 of the present invention;
Fig. 64 is a cross section showing a LED element in embodiment 9 of the present invention;
Fig. 65 is a cross section showing a LED element in another conformation of embodiment 9 of the present invention;
Fig. 66 is a first cubic diagram showing a light emitting element array using LED element in embodiment 9 of the present invention;
Fig. 67 is a second cubic diagram showing a light emitting element array using LED element in embodiment 9 of the present invention;
Fig. 68 is a cross section showing a LED head of the present invention;
Fig. 69 is a plane diagram showing a LED unit of the present invention;
Fig. 70 is a cross section showing a LED head in embodiment 11 of the present invention;
Fig. 71 is a cubic diagram showing a LED head in embodiment 11 of the present invention;
Fig. 72 is a cross section showing a main part of image forming apparatus of the present invention; and
Fig. 73 is a block diagram showing an exposure controlling system in image forming apparatus of the present invention.

### DETAILED DESCRIPTION OF THE PREFERRED EMBODIMENTS

Best embodiments of the invention will be described in detail hereinbelow with reference to the drawings.

### <Embodiment 1>

In the embodiment, a structure is adopted to set a distance between a main heat producing region and a substrate with high heat conductivity as short as possible so as to efficiently conduct heat energy toward external of semiconductor device.

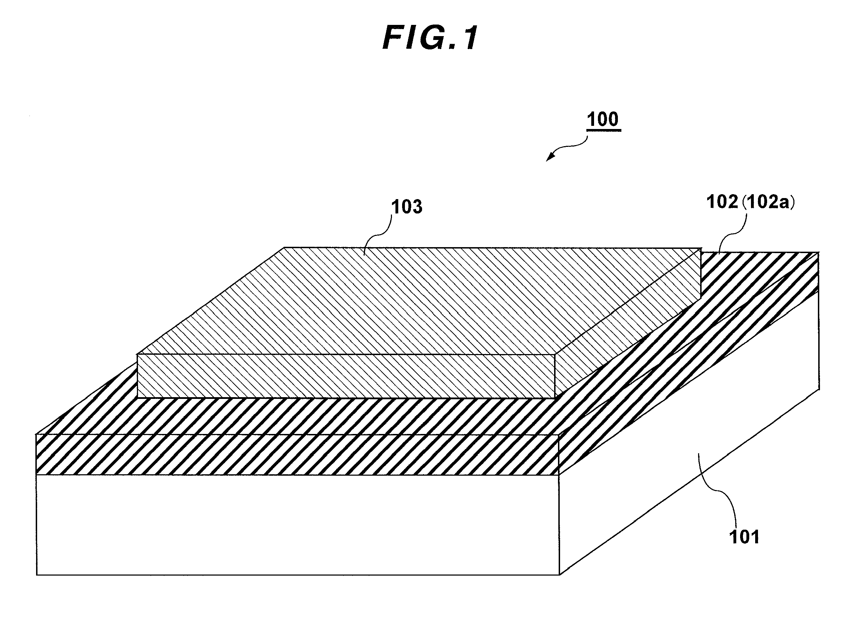

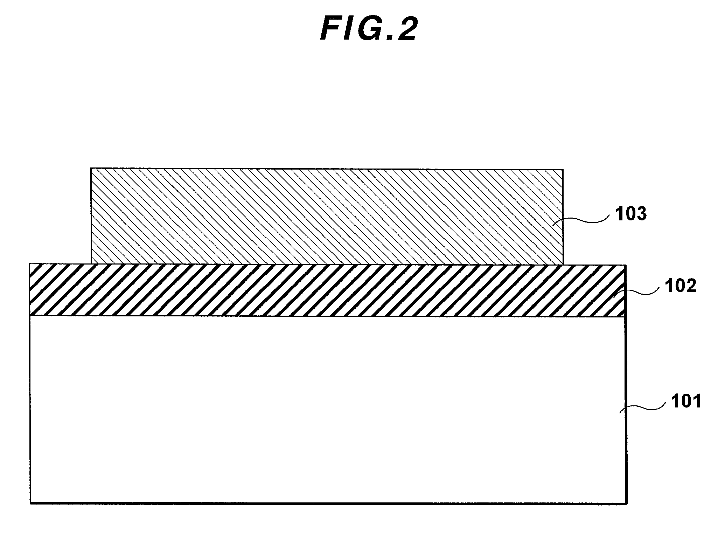

Fig. 1 is a cubic diagram showing a semiconductor device in embodiment 1 of the present invention; and Fig. 2 is a cross section showing a semiconductor device in embodiment 1 of the present invention.

As shown by the Figs. 1 and 2, in a semiconductor device 100 in embodiment 1, a surface coating layer 102 covers a surface of a metallic substrate 101, on the surface coating layer 102, a semiconductor thin film layer 103 is stuck. Though a structure of the semiconductor thin film layer 103 is not shown in the Fig. 2, the semiconductor thin film layer 103 is a semiconductor thin film comprising semiconductor element. The semiconductor element may be, for example, light emitting diode, semiconductor laser, integrated circuit, sensor, light receiving element and the like; and singular semiconductor element or plural semiconductor elements may be used. Further, various kinds of semiconductor elements may be mixed to use.

As a material of the metallic substrate 101, it is desired to adopt such material with high heat conductivity as, for example, Cuprum, Aluminum, Brass (an alloy of Cuprum and Zinc), Zinc, Tungsten, Nickel, Bronze (an alloy of Cuprum and Tin), Molybdenum or the like. As a surface roughness of substrate surface of the metallic material, it is desired that an average surface roughness is set at 5 nm or below. Here, the average surface roughness means an average value of surface roughness Ra (average Roughness) obtained from measured surface roughnesses in a measurement area (for example, as a typical example, a measurement area of 5µm~25µm) through an AFM (Atomic Force Microscope).

Further, in the measurement area, it is more desired that a maximum roughness RPV is 5nm or below. Here, the maximum roughness RPV, i.e. the maximum surface roughness means a rugged difference of an area in the measurement area, in which the surface roughness is peculiarly obvious. In the case that such peculiar area exists, because a defective semiconductor thin film bonding to the surface of the peculiar area together will happen, it is not desired without the peculiar area.

Further, it is desired that a maximum undulation Rmax of surface is set at 1/500 or below, it is best to be set at 1/1000 or below. Here, the maximum undulation Rmax of surface means a maximum rugged difference Dmax in a position corresponding to one measurement distance L when using, for example, a surface roughness measurer (it is an appraising device to measure a rugged state of surface through using needle to trace the surface) to measure rugged profiles of surface. For example, in the case that Rmax=Dmax//L≤1/1000, it means that when the distance L is L=50 µm, the maximum rugged difference Dmax is 50 µm or below. Furthermore, the measurement distance L is desired to be L≥10 µm.

The surface coating layer 102 is a, for example, diamond-like carbon layer 102a for cover the surface of the metallic substrate 101. The diamond-like carbon layer 102a is a carbon material similar to diamond, and has high insulativity and high heat conductivity. Further, the diamond-like carbon layer 102a also may be an amorphous carbon material having a structure that includes an intermediate structure intervening between a diamond coupling (SP3 structure) and a graphite coupling (SP2 structure). Furthermore, the diamond-like carbon layer 102a may contain some hydrogen according to condition.

The diamond-like carbon layer 102a can be formed by, for example, Plasma CVD (Chemical Vapor Deposition) method, sputtering method, ion plating method or the like. The diamond-like carbon layer 102a is also desired to be flat without peculiar roughness (hillock or the like) on its own surface as the metallic substrate 101.

In the state to cover the metallic substrate 101, the surface flatness of the diamond-like carbon layer 102a is desired that its average value of surface roughness Ra in measurement area is 5nm or below, best is 2nm or below. This desire is based on a result that the semiconductor thin film is difficultly bonded when the Ra exceeds 5 nm in a systematic experimentation of inventor. Further, it is desired that the maximum roughness RPV (i.e. maximum peak height) in measurement area is 10nm or below, best is 5nm or below. Furthermore, it is desired that the maximum undulation Rmax is 1/1000 or below. In general, there is a tendency that the Ra also increases with the thickness of the semiconductor thin film increases. In order to set the Ra at 2nm or below, for example, it is desired to set the thickness of the diamond-like carbon layer 102a at 1 µm or below.

The following is to explain a case to apply the present invention to a LED element serving as semiconductor element. In the case, as an example, the semiconductor thin film layer 103 serves as a LED thin film layer to form light emitting element.

The LED thin film layer is directly bonded on a diamond layer or the diamond-like carbon layer 102a by intermolecular interaction, without needing adhesive or gluing material to intervene. The following is to explain concrete element conformation and manufacturing method of the semiconductor thin film layer 103.

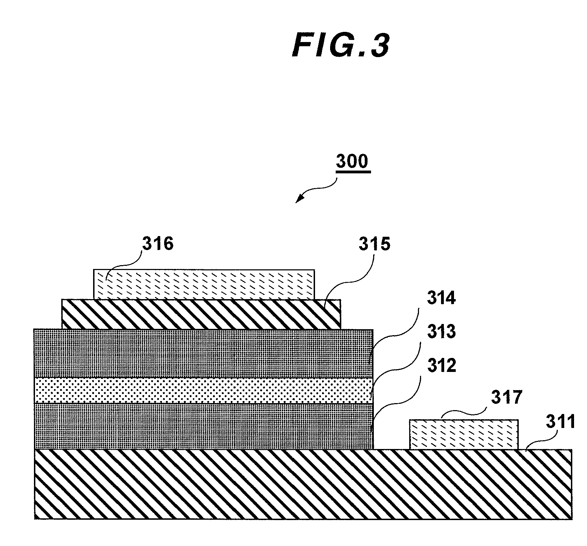

Fig. 3 is a cross section showing a LED element in embodiment 1 of the present invention.

The drawing shows a concrete example (i.e. a LED element 300) of the semiconductor thin film layer 103 of the embodiment 1. As shown by the Fig. 3, a symbol 311 represents a first electroconductive side GaAs layer; a symbol 312 represents an AlₓGa₁₋ₓAs layer (clad layer); a symbol 313 represents a first electroconductive type Al_{y}Ga_{1-y}As layer (active layer); a symbol 314 represents a second electroconductive type Al_{z}Ga_{1-z}As layer (clad layer); and a symbol 315 represents a second electroconductive side GaAs layer (contact layer). Here, at least it is desired that y<x, and y<z. Further, a symbol 316 represents a second electroconductive side electrode; and a symbol 317 represents a first electroconductive side electrode. The following is to explain a summary of manufacturing method of LED element 300.

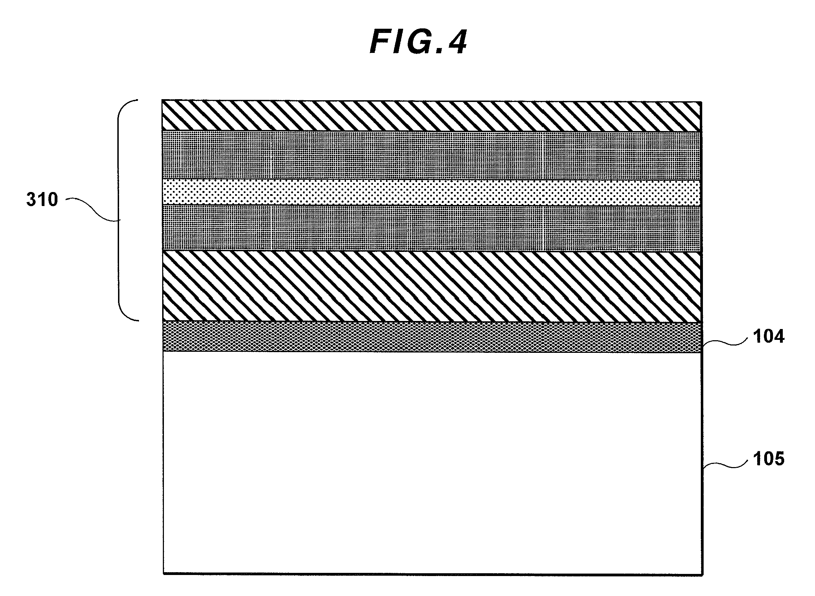

Fig. 4 is a first diagram for explaining a manufacturing method of LED element in embodiment 1 of the present invention.

As shown by the Fig. 4, a LED thin film layer 310 serving as material of the LED element 300 is formed on a sacrifice layer 104 (e.g. AlₜGa₁₋ₜAs layer, t≥0.6) which is furnished on a GaAs substrate 105. For example, an OMCVD (Organic Metal Chemical Vapor Deposition) method is used to form the thin film layer.

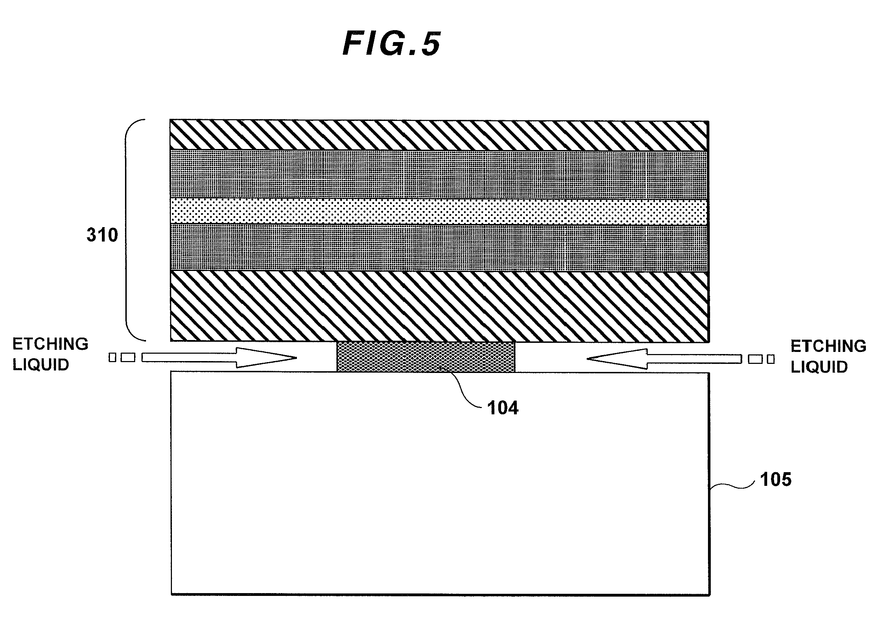

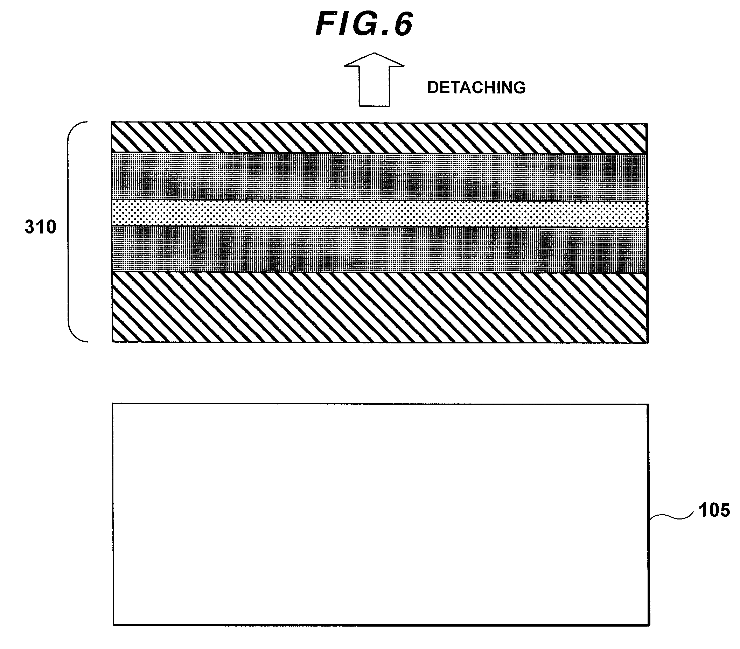

Fig. 5 is a second diagram for explaining a manufacturing method of LED element in embodiment 1 of the present invention; and Fig. 6 is a third diagram for explaining a manufacturing method of LED element in embodiment 1 of the present invention.

As shown by the Figs. 5 and 6, through using etching liquid to only etch the sacrifice layer 104, the sacrifice layer 104 is selectively etched. Though etching the sacrifice layer 104, the LED thin film layer 310 is detached from the GaAs substrate 105.

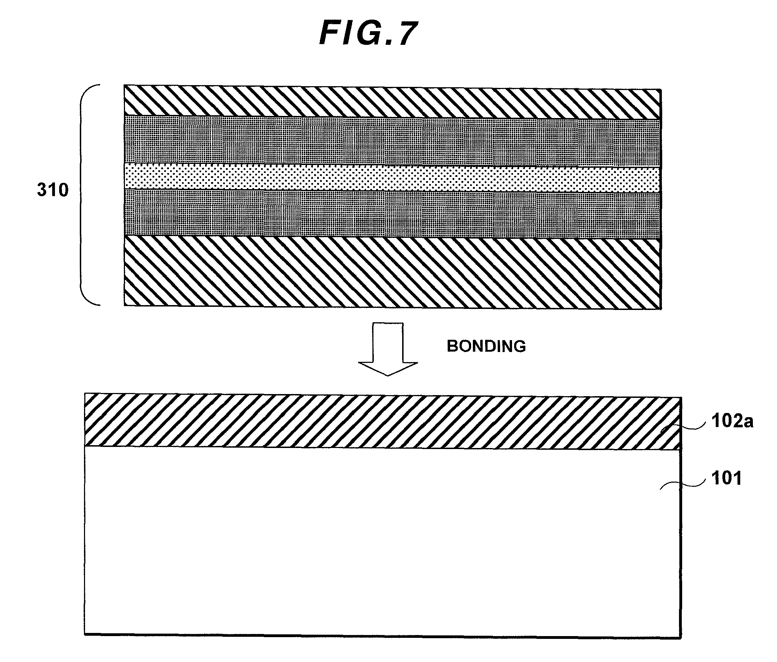

Fig. 7 is a fourth diagram for explaining a manufacturing method of LED element in embodiment 1 of the present invention.

As shown by the Fig. 7, the LED thin film layer 310 is put on the diamond-like carbon layer 102a which is formed on the metallic substrate 101, contacts with the diamond-like carbon layer 102a and is bonded on the diamond-like carbon layer 102a. The bonding surface is suitably processed and it is desired to perform a strong bonding.

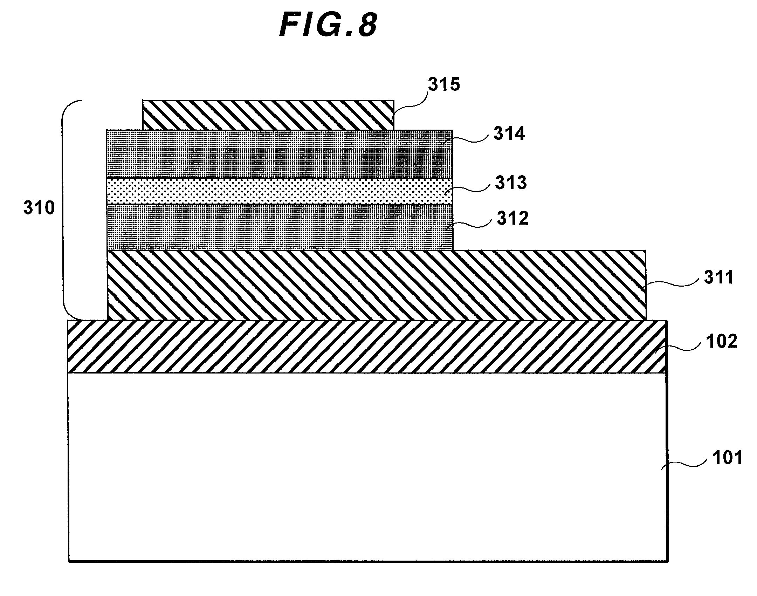

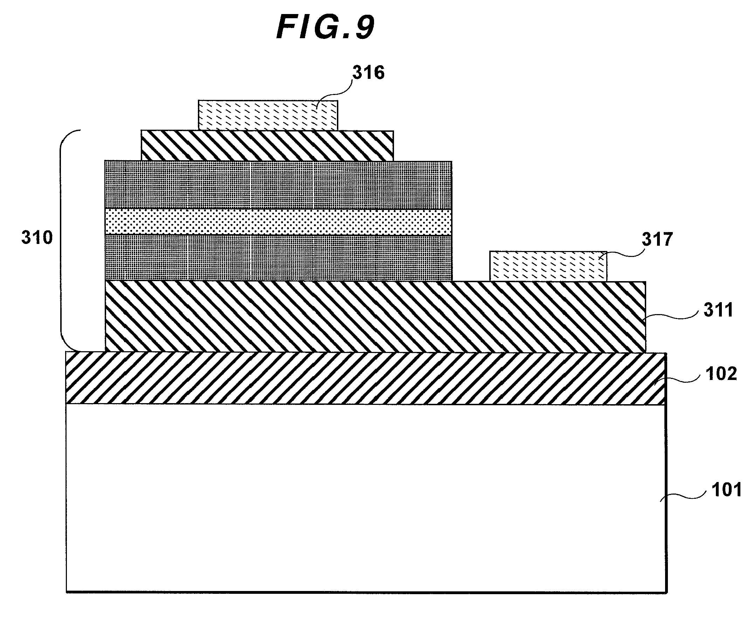

Fig. 8 is a fifth diagram for explaining a manufacturing method of LED element in embodiment 1 of the present invention; and Fig. 9 is a sixth diagram for explaining a manufacturing method of LED element in embodiment 1 of the present invention.

As shown by the Figs. 8 and 9, after the LED thin film layer 310 is bonded on the diamond-like carbon layer 102a, these layers from the AlxGal-xAs layer (clad layer) 312 to the second electroconductive side GaAs layer (contact layer) 315 are etched so as to expose the first electroconductive side GaAs layer 311. Then, though respectively forming the first electroconductive side electrode 317 and the second electroconductive side electrode 316 onto the first electroconductive side GaAs layer 311 and the second electroconductive side GaAs layer (contact layer) 315, the element is performed. Here, the first electroconductive side electrode 317 may be, for example, an AuGe/Ni/Au layer, or an AuGeNi/Au layer; the second electroconductive side electrode 316 may be, for example, a Ti/Pt/Au layer, an Al layer or a Ni/Al layer so that the LED can obtains a thin film layer 310a. In the manufacturing method shown by the Figs. 4∼9, the conformation of the LED is processed after bonded the semiconductor thin film layer. However, it is possible to previously form the structure shown by the Fig. 3 onto the GaAs substrate, and use the same method as shown by the Figs. 4∼6 to detach, further perform a bonding on the diamond-like carbon layer as shown by the Fig. 7.

As examples, the following is to explain LED element of conformations [1]~[14] that are different from the explained-above LED element (Fig. 3) in embodiment 1.

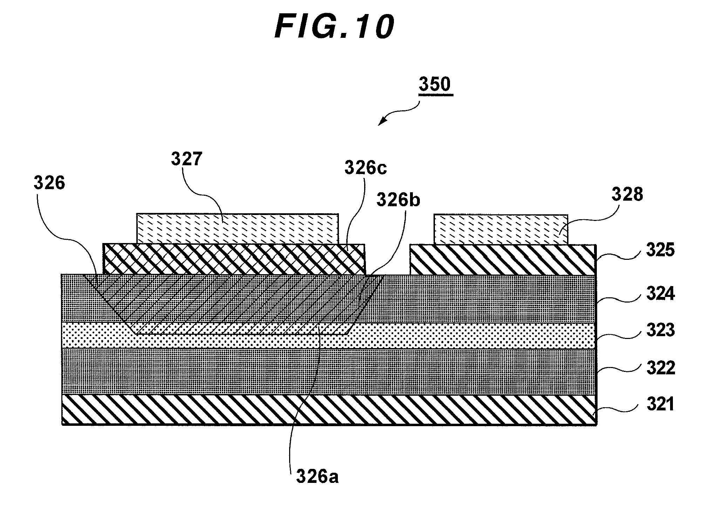

Fig. 10 is a cross section showing a LED element in another conformation [1] of embodiment 1 of the present invention.

As shown by the Fig. 10, a symbol 321 represents a first electroconductive side GaAs layer; a symbol 322 represents an AlₓGa₁₋ₓAs layer (clad layer); a symbol 323 represents a first electroconductive type Al_{y}Ga_{1-y}As layer (active layer); a symbol 324 represents a second electroconductive type Al_{z}Ga_{1-z}As layer (clad layer); a symbol 325 represents a second electroconductive side GaAs layer (contact layer); and a symbol 326 represents a second electroconductive type impurity diffusing area. The diffusing area at least arrives at the first electroconductive type Al_{y}Ga_{1-y}As layer (active layer) 323. Further, a symbol 326a represents a diffusing area in active layer; a symbol 326b represents a diffusing area in clad layer; and a symbol 326c represents a diffusing area in contact layer. The diffusing area 326c in contact layer and the second electroconductive side GaAs layer (contact layer) 325 are at least separated by etching. Furthermore, a symbol 328 represents a first electroconductive side electrode; and a symbol 327 represents a second electroconductive side electrode.

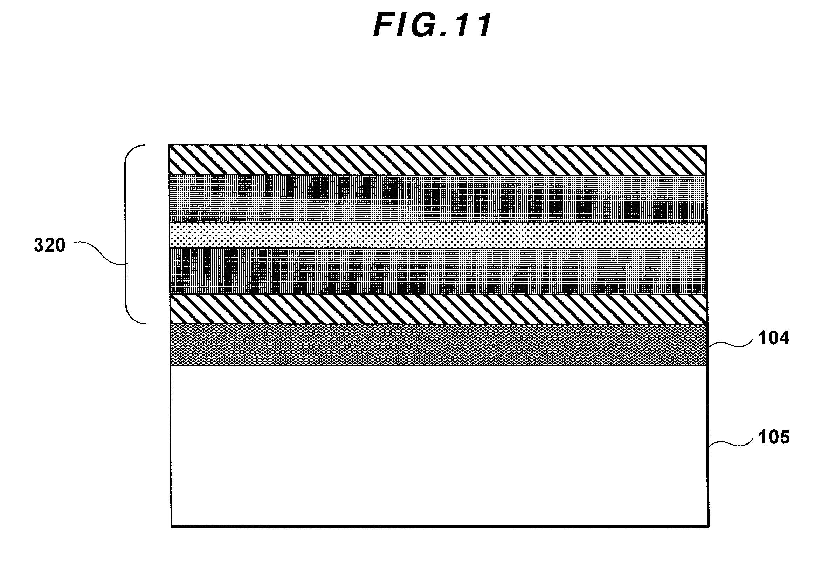

Fig. 11 is a first diagram for explaining a manufacturing method of LED element in another conformation [1] of embodiment 1 of the present invention.

As shown by the Fig. 11, a sacrifice layer 104 (e.g. AlₜGa₁₋ₜAs layer, t≥0.6) is furnished on a GaAs substrate 105, and a LED thin film layer 320 is formed on the sacrifice layer 104. Likewise, the LED thin film layer 320 is formed by an OMCVD method and the like as stated above.

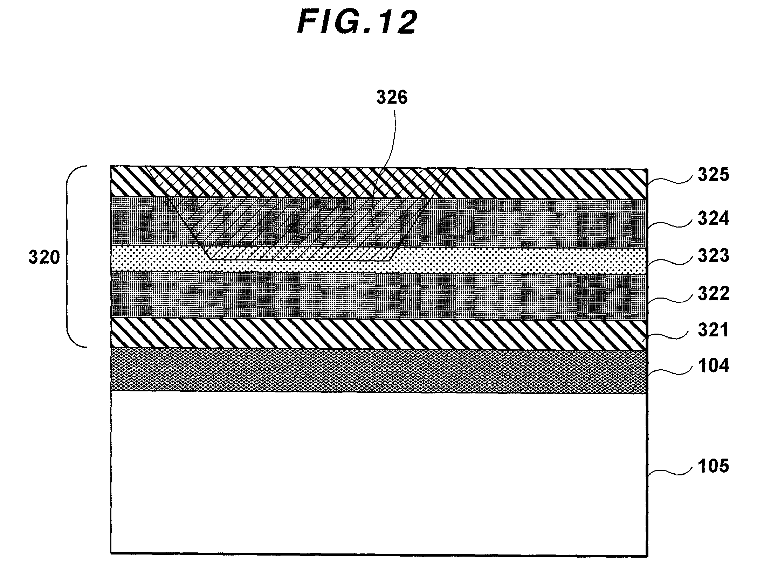

Fig. 12 is a second diagram for explaining a manufacturing method of LED element in another conformation [1] of embodiment 1 of the present invention.

Next, the second electroconductive type impurity diffusing area 326 which arrives at the active layer is formed. The impurity is, for example, Zn. It is possible to form a ZnO thin film on the diffusing area and diffuse the impurity through heating at a temperature of 550°C ~650°C.

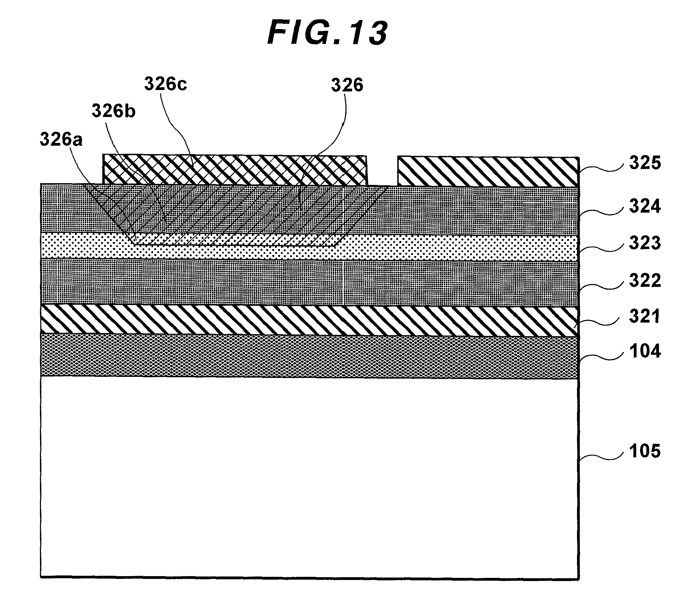

Fig. 13 is a third diagram for explaining a manufacturing method of LED element in another conformation [1] of embodiment 1 of the present invention.

As shown by the Fig. 13, the second electroconductive side GaAs layer (contact layer) 325 and the diffusing area 326c in contact layer are separated.

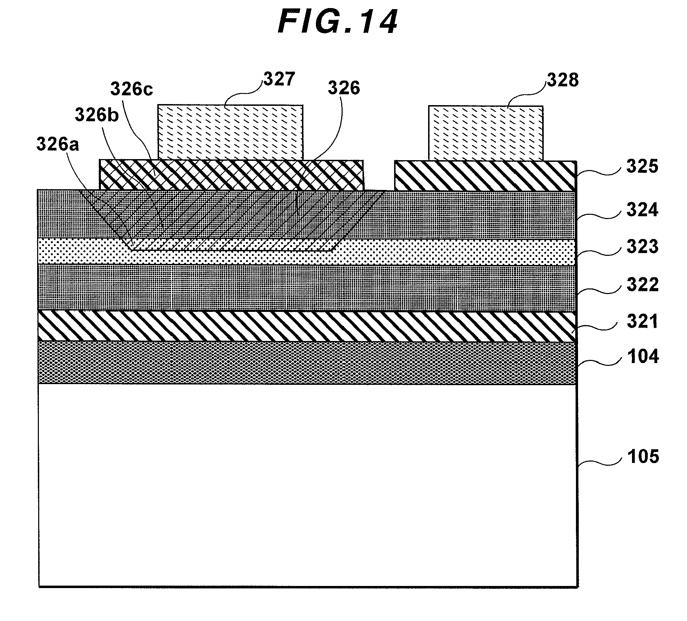

Fig. 14 is a fourth diagram for explaining a manufacturing method of LED element in another conformation [1] of embodiment 1 of the present invention.

As shown the Fig. 14, the first electroconductive side electrode 328 and the second electroconductive side electrode 327 are formed.

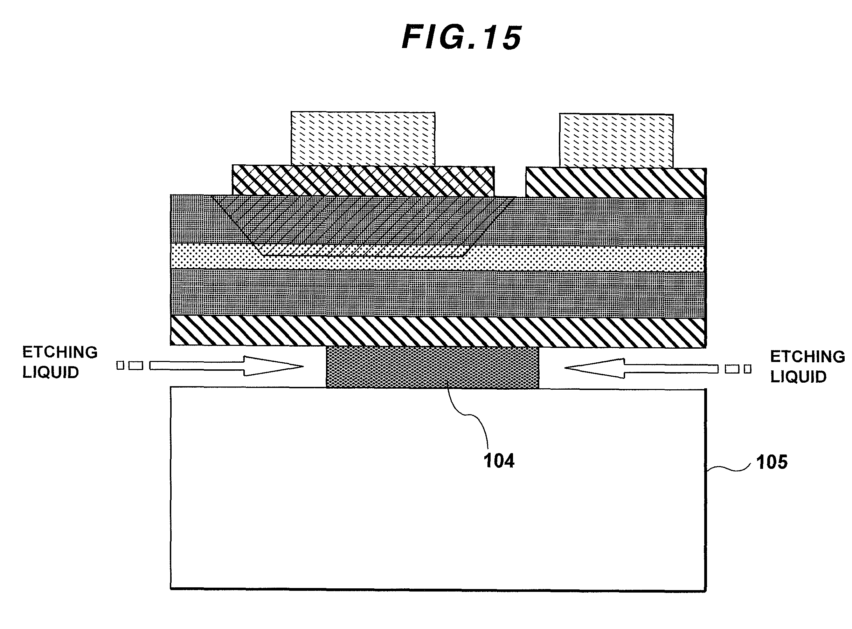

Fig. 15 is a fifth diagram for explaining a manufacturing method of LED element in another conformation [1] of embodiment 1 of the present invention.

Next, a supporting body (not shown) is suitably furnished on the surface, and the sacrifice layer 104 is removed by selectively etching.

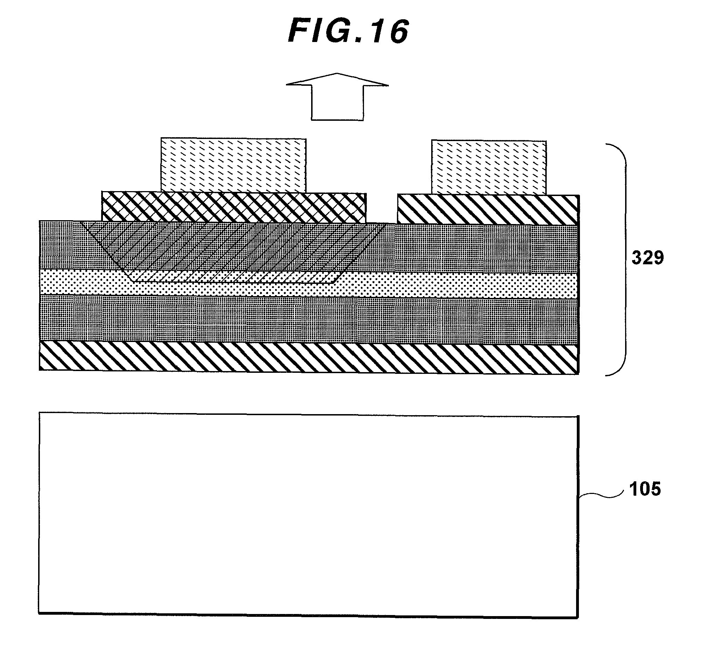

Fig. 16 is a sixth diagram for explaining a manufacturing method of LED element in another conformation [1] of embodiment 1 of the present invention.

As shown by the Fig. 16, through completely removing the sacrifice layer 104 in etching, a LED thin film element 329 is detached from the GaAs substrate 105.

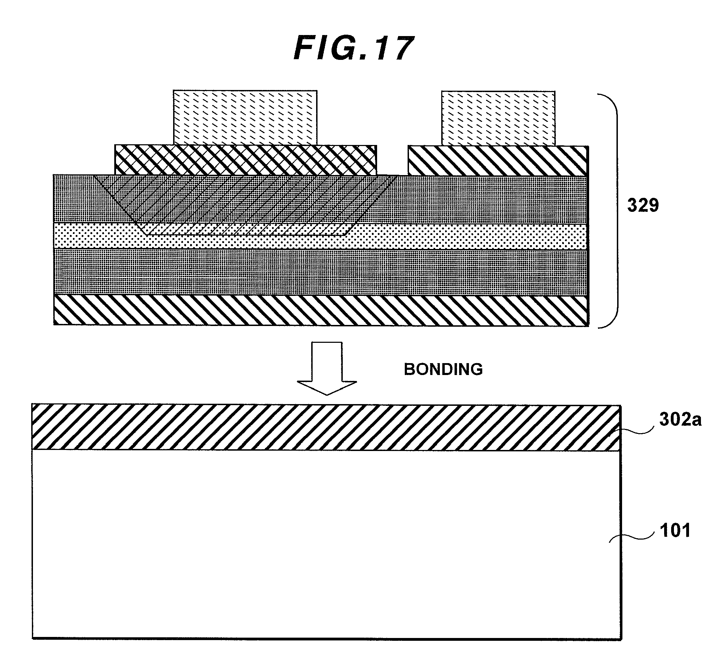

Fig. 17 is a seventh diagram for explaining a manufacturing method of LED element in another conformation [1] of embodiment 1 of the present invention.

As shown by the Fig. 17, on a substrate in which a diamond-like carbon layer 302a is formed on the metallic substrate 101, the LED thin film element 329 is stuck to and bonded.

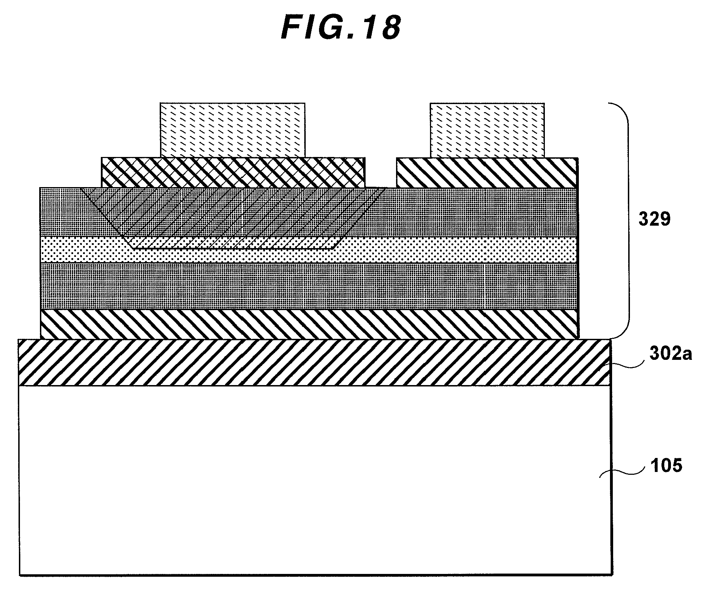

Fig. 18 is an eighth diagram for explaining a manufacturing method of LED element in another conformation [1] of embodiment 1 of the present invention.

Through the above-stated processes, as shown by the Fig. 18, a LED element is performed.

Continuously, as an example, the following is to explain LED element of conformation [2] that are different from the explained-above LED element (Fig. 3) in embodiment 1.

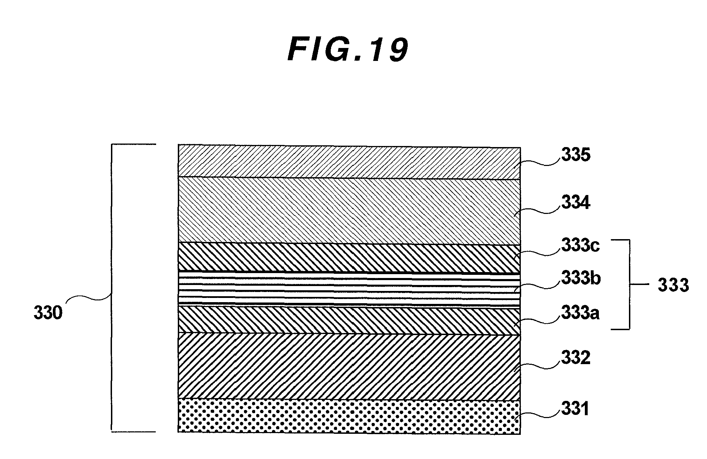

Fig. 19 is a cross section showing a LED thin film layer in another conformation [2] of embodiment 1 of the present invention.

In the Fig. 19, a symbol 331 represents a buffer layer, for example, AlN layer; a symbol 332 represents a n-GaN layer; a symbol 333 represents a multiple quantum well layer; a symbol 333a represents an InGaN layer; a symbol 333b represents an GaN/InGaN GaN/....../InGaN/GaN accumulative layer; a symbol 333c represents an InGaN layer; a symbol 334 represents a p-InGaN layer; and a symbol 335 represents a p-GaN layer.

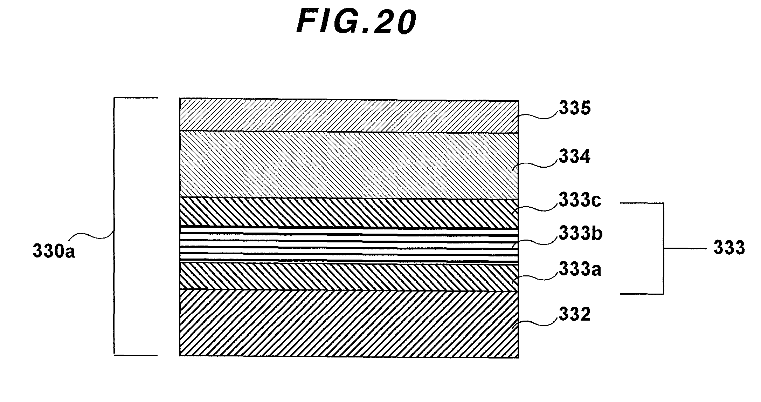

Fig. 20 is a cross section showing a LED thin film layer in another conformation [3] of embodiment 1 of the present invention.

As shown by the Fig. 20, in a LED thin film layer 330a of another conformation [3], as compared with the LED thin film layer 330 of conformation [2], there is no the buffer layer 331 (Fig. 19).

The following is to explain manufacturing method of another conformations [2] and [3].

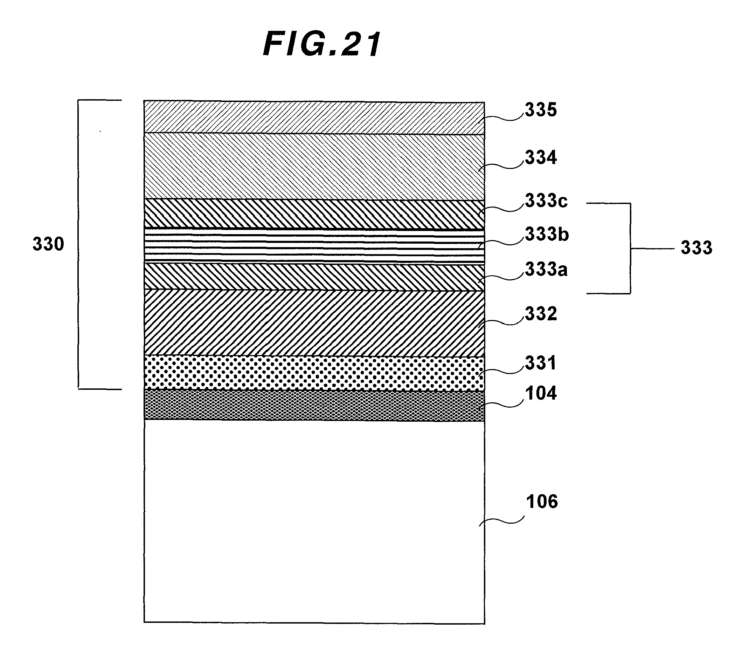

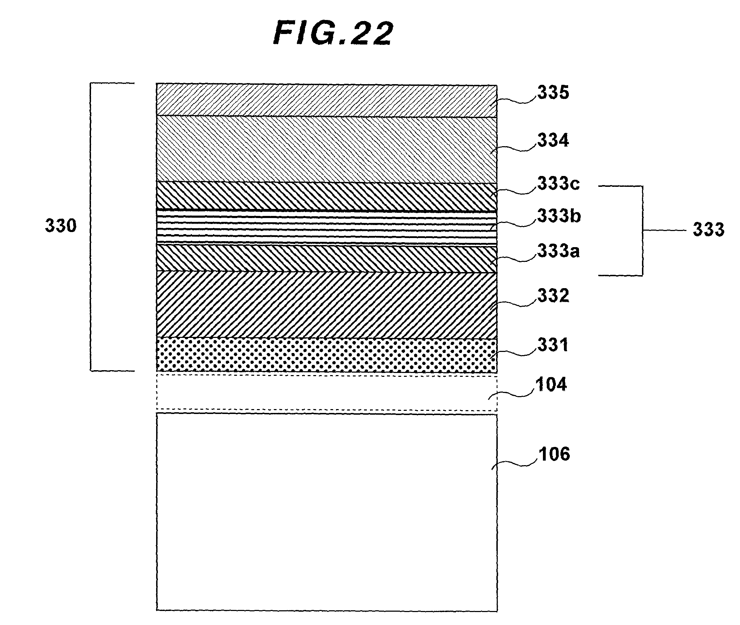

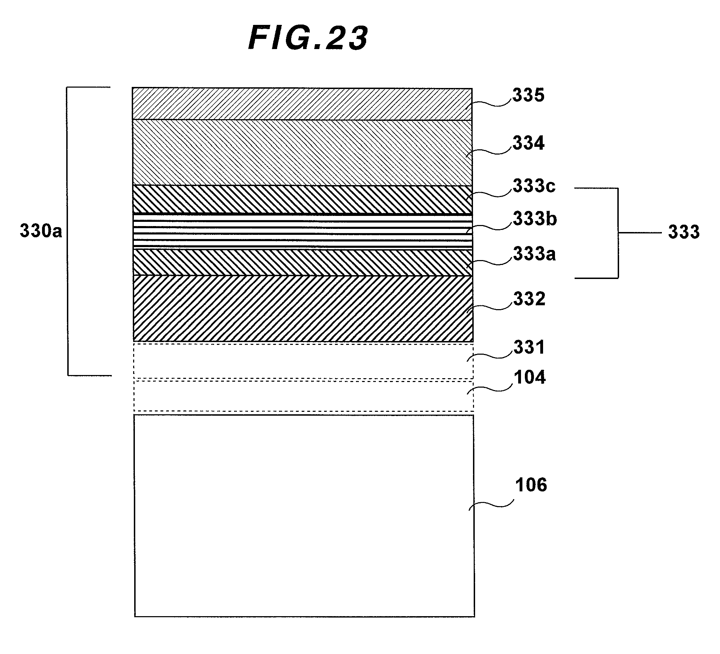

Fig. 21 is a first diagram for explaining a manufacturing method of LED thin film layer in another conformation [2] of embodiment 1 of the present invention; Fig. 22 is a second diagram for explaining a manufacturing method of LED thin film layer in another conformation [2] of embodiment 1 of the present invention; and Fig. 23 is a third diagram for explaining a manufacturing method of LED thin film layer in another conformation [2] of embodiment 1 of the present invention.

In the Fig. 21, a symbol 106 represents a sapphire substrate (an example); and a symbol 104 represents a sacrifice layer. As shown by the Fig. 22, through removing the sacrifice layer 104 in a selective etching method the LED thin film layer 330 is detached from the sapphire substrate 106. As shown by the Fig. 23, through etching the buffer layer 331 together with the sacrifice layer 104, the LED thin film layer 330a can be obtained.

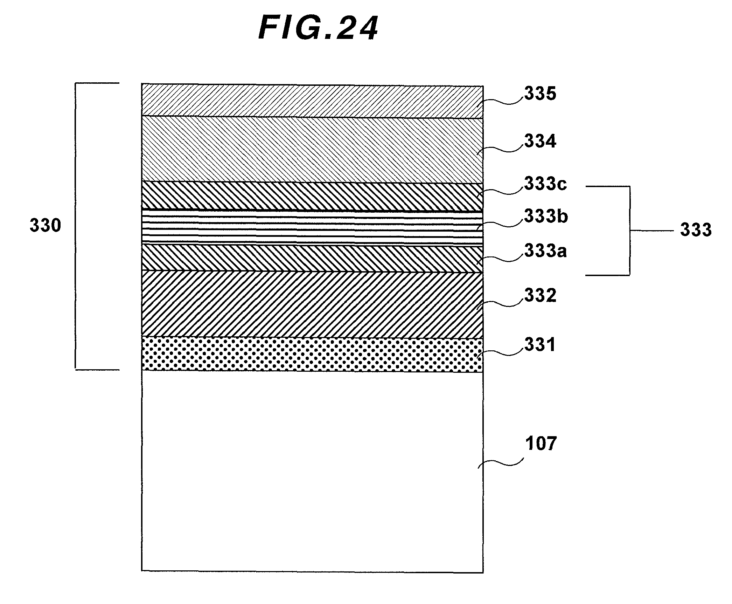

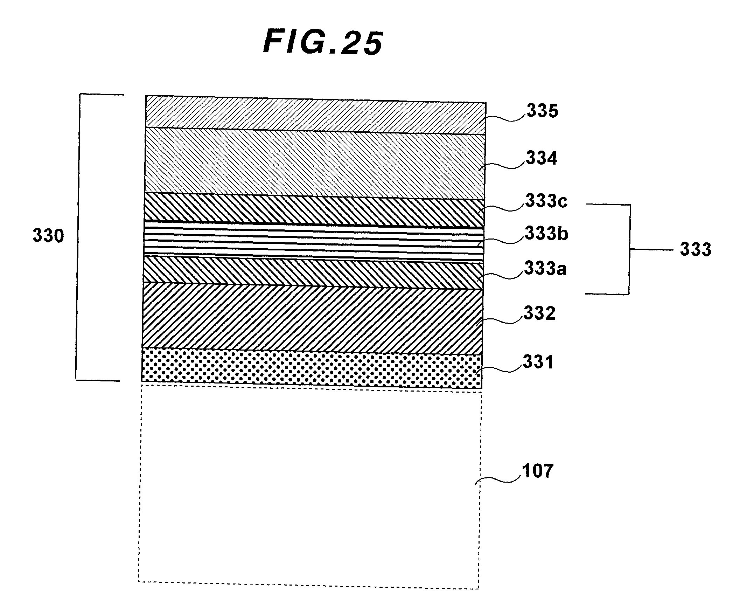

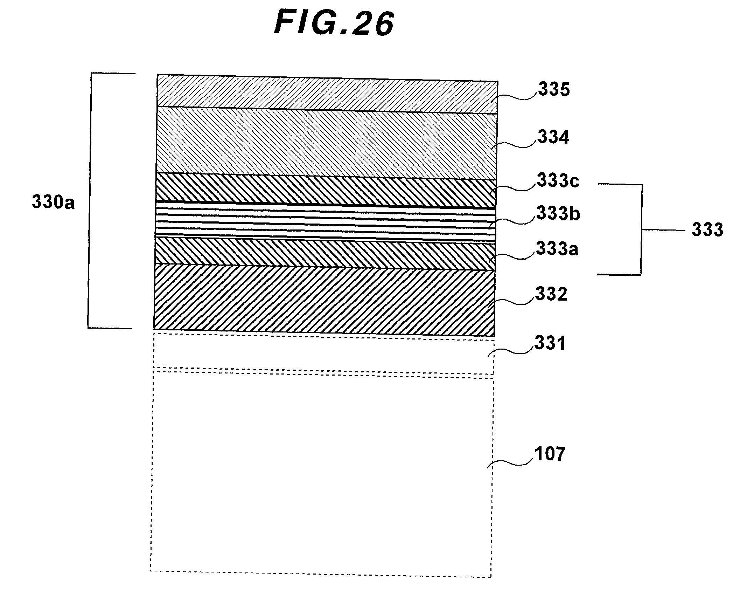

Fig. 24 is a first diagram for explaining a manufacturing method of LED thin film layer in another conformation [3] of embodiment 1 of the present invention; Fig. 25 is a second diagram for explaining a manufacturing method of LED thin film layer in another conformation [3] of embodiment 1 of the present invention; and Fig. 26 is a third diagram for explaining a manufacturing method of LED thin film layer in another conformation [3] of embodiment 1 of the present invention.

As shown by the Fig. 24, different from the example shown by the Fig. 21, it is the case to directly furnish the buffer layer 331 onto a Si substrate 107 (an example) without furnishing the sacrifice layer 104 (Fig. 21). The substrate in Fig. 24 is a, for example, Si substrate 107. As shown by the Fig. 25, through etching the Si substrate 107, the LED thin film layer 330 can be obtained. As shown by the Fig. 26, through removing the buffer layer 331 in etching method while etching the Si substrate 107, the LED thin film layer 330a can be obtained. In the conformation shown by the Figs. 25 and 26, it is possible to remove all the Si substrate 107 by etching. Also it is possible to perform a transverse etching with respect to one side at which the LED thin film layer is formed, mainly through an etching method in which a transverse etching speed is quicker then a lengthways etching speed. In the case, only a part of the upper surface of the Si substrate is etched.

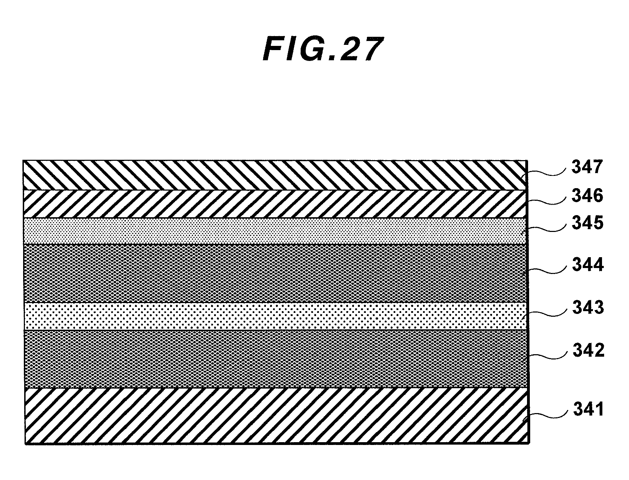

Fig. 27 is a cross section showing a LED thin film layer in another conformation [4] of embodiment 1 of the present invention.

As shown by the Fig. 27, a symbol 341 represents a n-GaAs layer; a symbol 342 represents a n-AlInGaP layer (clad layer); a symbol 343 represents a non-dope InGaP layer (active layer); a symbol 344 represents a p-AlInGaP layer (clad layer); a symbol 345 represents a p-InGaP layer (buffer layer); a symbol 346 represents a n-GaAs layer; and a symbol 347 represents a p-GaAs layer.

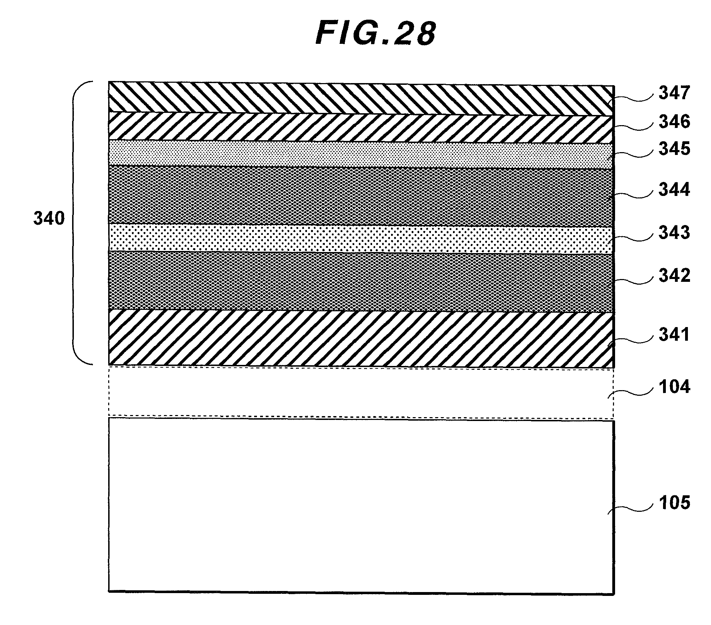

Fig. 28 is a diagram for explaining a manufacturing method of LED thin film layer in another conformation [4] of embodiment 1 of the present invention.

As shown by the Fig. 28, for example, through selectively etching the sacrifice layer 104 furnished on the GaAs substrate 105, a LED thin film layer 340 can be obtained.

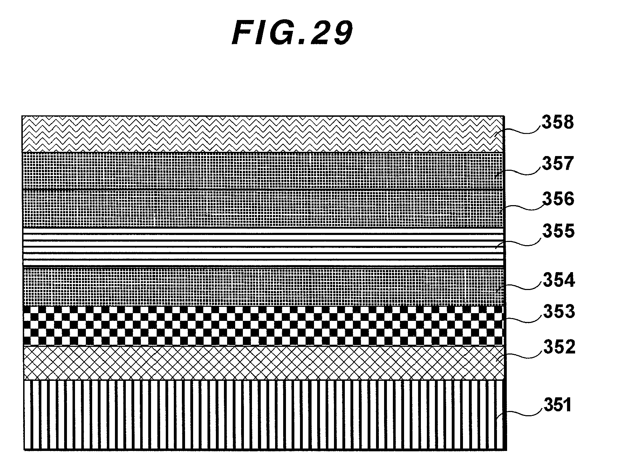

Fig. 29 is a cross section showing a LED thin film layer in another conformation [5] of embodiment 1 of the present invention.

As shown by the Fig. 29, a symbol 351 represents a n-InP layer; a symbol 352 represents a n-InGaAsP layer; a symbol 353 represents a n-InP layer; a symbol 354 represents a n-InP layer (clad layer); a symbol 355 represents an InGaAs/ InGaAsP layer (multiple quantum well layer); a symbol 356 represents a p-InP layer (clad layer); a symbol 357 represents an InP layer; and a symbol 358 represents a p-InGaAs layer (contact layer).

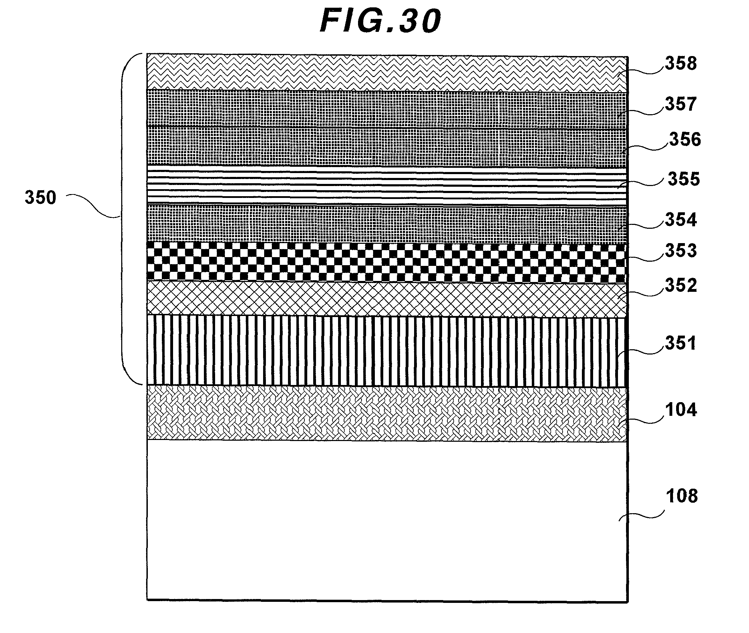

Fig. 30 is a cross section showing a LED thin film layer in another conformation [6] of embodiment 1 of the present invention.

The Fig. 30 shows an example of an epitaxial substrate structure for obtaining a LED thin film layer 350. As shown by the Fig. 30, a symbol 108 represents an, for example, InP substrate; and a symbol 104 represents a sacrifice layer furnished between the LED thin film layer 350 and the InP substrate 108.

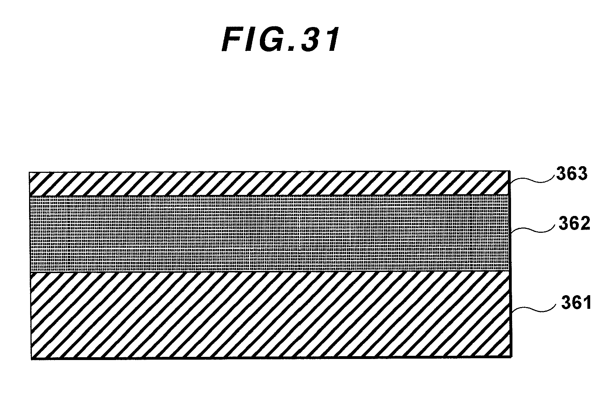

Fig. 31 is a cross section showing a LED thin film layer in another conformation [7] of embodiment 1 of the present invention.

As shown by the Fig. 31, a symbol 361 represents a non-dope GaAs layer; a symbol 362 represents a n-AlGaAs layer; and a symbol 363 represents a n-GaAs layer.

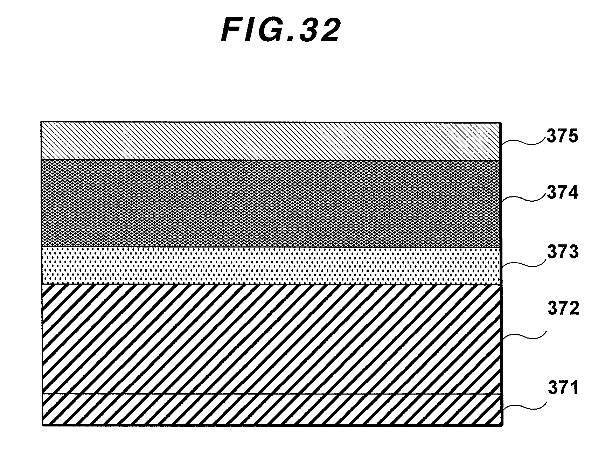

Fig. 32 is a cross section showing a LED thin film layer in another conformation [8] of embodiment 1 of the present invention.

As shown by the Fig. 32, a symbol 371 represents a n-GaAs layer; a symbol 372 represents a n-GaAs layer; a symbol 373 represents a p-AlGaAs layer; a symbol 374 represents a n-AlGaAs layer; and a symbol 375 represents a n-GaAs layer or n-InGaAs layer.

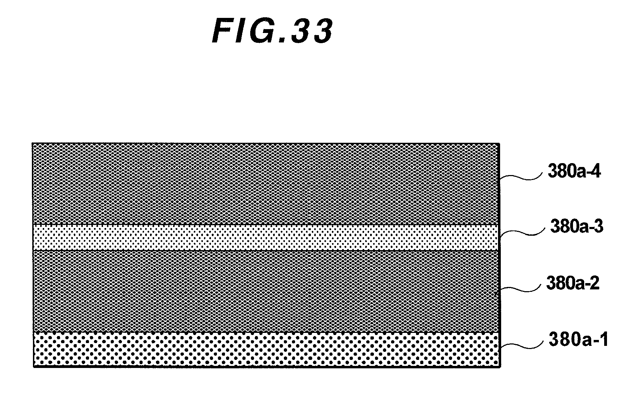

Fig. 33 is a cross section showing a LED thin film layer in another conformation [9] of embodiment 1 of the present invention.

As shown by the Fig. 33, a symbol 380a-1 represents an AlN layer; a symbol 380a-2 represents a n-AlₓGa₁₋ₓN layer; a symbol 380a-3 represents an Al_{y}Ga_{1-y}N layer; and a symbol 380a-4 represents a p-Al_{z}Ga_{1-z}N layer.

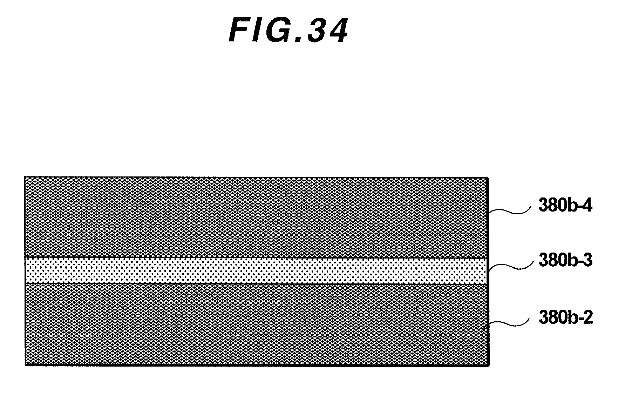

Fig. 34 is a cross section showing a LED thin film layer in another conformation [10] of embodiment 1 of the present invention.

As shown by the Fig. 34, a symbol 380b-2 represents a n-AlₓGa₁₋ₓN layer; a symbol 380b-3 represents an Al_{y}Ga_{1-y}N layer; and a symbol 380b-4 represents a p-Al_{z}Ga_{1-z}N layer.

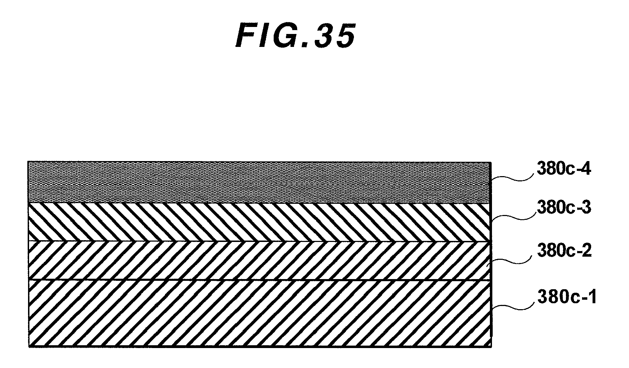

Fig. 35 is a cross section showing a LED thin film layer in another conformation [11] of embodiment 1 of the present invention.

As shown by the Fig. 35, a symbol 380c-1 represents a n⁺-GaN layer; a symbol 380c-2 represents a n-GaN layer; a symbol 380c-3 represents a p-GaN layer; and a symbol 380c-4 represents a n⁺-AlGaN layer.

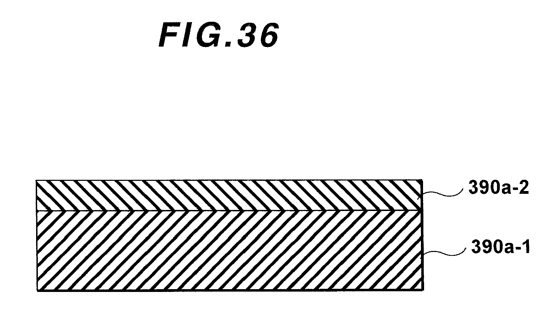

Fig. 36 is a cross section showing a LED thin film layer in another conformation [12] of embodiment 1 of the present invention.

As shown by the Fig. 36, a symbol 390a-1 represents a non dope GaN layer; and a symbol 390a-2 represents a n-GaN layer.

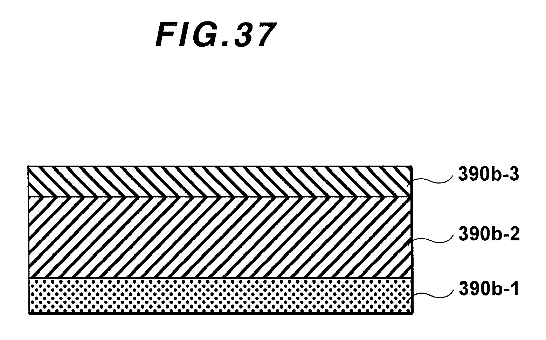

Fig. 37 is a cross section showing a LED thin film layer in another conformation [13] of embodiment 1 of the present invention.

As shown by the Fig. 37, a symbol 390b-1 represents an AlN layer; a symbol 390b-2 represents a non dope GaN layer; and a symbol 390b-3 represents a n-GaN layer.

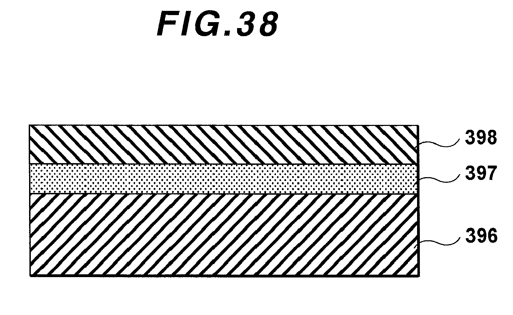

Fig. 38 is a cross section showing a LED thin film layer in another conformation [14] of embodiment 1 of the present invention.

As shown by the Fig. 38, a symbol 396 represents a non dope GaN layer; a symbol 397 represents a non dope AlGaN layer; and a symbol 398 represents a n-AlGaN layer.

As explained above, as semiconductor element, LED element, sensor element or electronic element respectively perform light emitting operation, sensing operation or transistor operation. The LED element, the sensor element or the electronic element produces heat while operating. In the case that the LED element produces heat, the heat is conducted to the diamond-like carbon layer with high heat conductivity which directly contacts with the LED element, further is conducted to the metallic substrate. Because the diamond-like carbon layer is thin, the heat is efficiently conducted in a thickness direction so as to be conducted to the metallic substrate. In the metallic material, the heat also is efficiently conducted and liberated toward external not only in a thickness direction but also in a transverse direction.

### Explanation of Effect:

As stated above, in the embodiment, as semiconductor thin film layer such as semiconductor element thin film layer and the like, for example, LED thin film layer, sensor thin film layer, or electronic element thin film layer, it is bonded on a diamond-like carbon layer which is thin and is furnished on a metallic substrate, and a distance between an operation layer such as active layer or the like and a substrate is shortened. Therefore, heat conductivity efficiency becomes high. Here, because the diamond-like carbon layer is thin, heat conductivity efficiency in thickness direction is not dropped. Further, in the metallic substrate, because heat conductivity rate also is high not only in a thickness direction but also in a transverse direction, the heat produced by the semiconductor element such as LED element, sensor element, electronic element or the like can be efficiently diffused toward external. So that it is possible to prevent a temperature rise of the semiconductor element such as LED element, sensor element, electronic element or the like. Therefore, not only it is possible to improve the operation characteristic of the LED element, the sensor element, the electronic element or the like; but also it is possible to sustain stable operation. Further, in the LED element, because the light emitted from a bottom surface can be reflected on the metallic surface, it is possible to improve light emitting characteristic.

### Explanation of transformation example:

In the above explanation, the diamond-like carbon layer is furnished between the LED thin film layer and the metallic substrate, instead of the diamond-like carbon layer, a diamond layer can be adopted. Furthermore, in the above-stated embodiment, the diamond-like carbon layer is formed only by a film growing method such as CVD and the like, a CMP (Chemical mechanical Polishing) method or the like may be further adopted in order to polish surface so as to obtain a flat surface.

Moreover, instead of the diamond-like carbon layer, such thin film with high heat conductivity as silicon carbide (SiC), oxidized aluminum (Al₂O₃) or the like. The SiC film can be formed by CVD method and the Al₂O₃ film can be formed by sputtering method.

### <Embodiment 2>

In the embodiment, as compared with the structure of the embodiment 1, a metal layer with high light reflectance is added to be separately furnished on a metallic substrate, in order to improve light emitting efficiency of light emitting element.

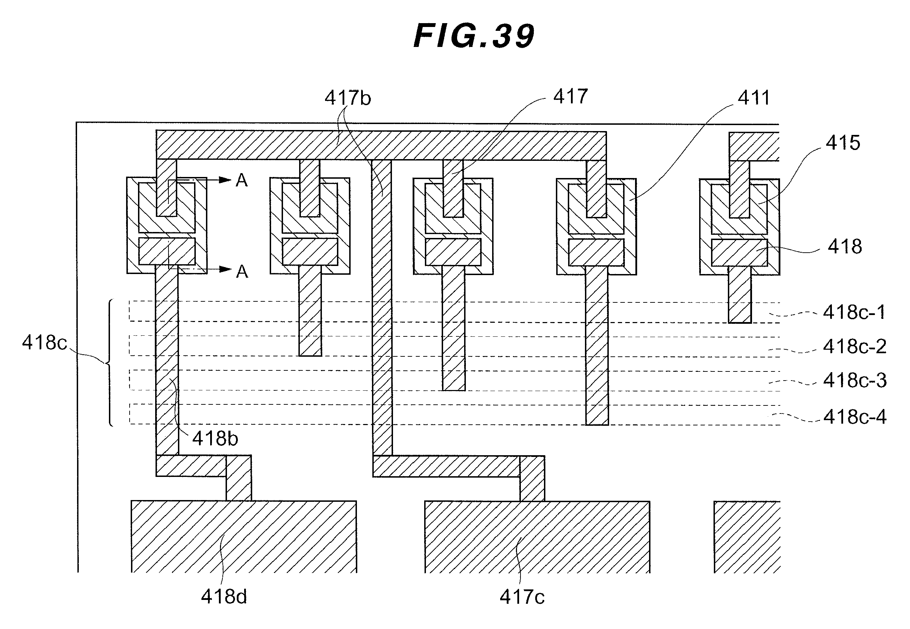

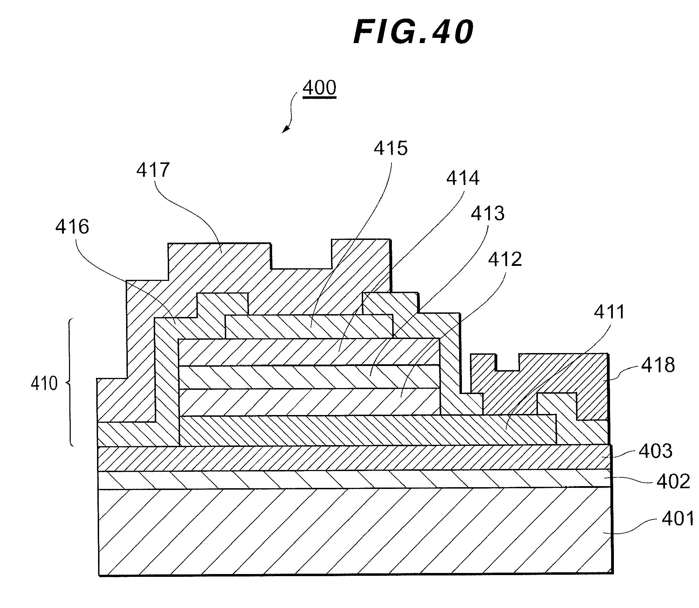

Fig. 39 is a plane diagram showing a LED device in embodiment 2 of the present invention; and Fig. 40 is a magnification diagram of A-A section in Fig. 39.

The following is to explain the embodiment 2 by referring to the two drawings.

As shown by the Fig. 39, a symbol 411 represents a first electroconductive side GaAs layer (contact layer); a symbol 415 represents a second electroconductive side GaAs layer (contact layer); and a symbol 417 represents a second electroconductive side electrode. Further, a symbol 417b represents second electroconductive side wiring; and a symbol 417c represents a second electroconductive side connection pad. Furthermore, a symbol 418b represents first electroconductive side wiring; a symbol 418c represents a common wiring to connect plural first electroconductive side electrodes; and a symbol 418d represents a first electroconductive side connection pad.

As shown by the Fig. 40, a symbol 401 represents a metallic substrate; and a symbol 402 represents a metal layer whose material is different from that of the metallic substrate 401. As a material of the metallic substrate 401, it is, for example, Cuprum, Aluminum, Brass (an alloy of Cuprum and Zinc), Zinc, Tungsten, Nickel, Bronze (an alloy of Cuprum and Tin), Molybdenum or the like. The metal layer 402 is a metal layer which at least has a reflectance being 50% or over with respect to at least one light with a wavelength band within 400nm~1500nm. As a material of the metal layer 402, it is, for example, Cuprum, an alloy containing Cuprum, Aluminum, Aluminum/Nickel, Zinc, Nickel, Platinum, Gold, Silver, an alloy containing Gold, an alloy containing Silver, Titanium, Tantalum, Palladium, Iridium, Tungsten or the like. The metal layer 402 can be formed by suitably selecting a method which is suitable for respective metallic materials, for example, it may use a method using a vacuum device, such as sputtering method, electronic beam vapor method or the like, also it may use a method without using a vacuum device, such as plating method, painting method or the like.

The metal layer 402 may be a single layer, also may be an accumulated layer. In the case that the metal layer 402 is an accumulated layer, it is desired that a most upper layer in the metal layer 402 has a high reflectance. Regarding a surface flatness of the metal layer 402, it is desired such as that in embodiment 1. That is, the average value of surface roughness Ra≤5nm, the maximum roughness RPV≤10nm, the maximum undulation Rmax≤1/1000.

A layer 403 is a diamond-like carbon layer, regarding a surface flatness of the diamond-like carbon layer 403, it is also desired such as that in embodiment 1. That is, the average value of surface roughness Ra≤5nm, the maximum roughness RPV≤10nm, the maximum undulation Rmax≤1/1000, best is that the average value of surface roughness Ra≤3nm, the maximum roughness RPV≤5nm.

A symbol 410 represents a LED element containing light emitting element. A symbol 411 represents a first electroconductive side GaAs layer (contact layer); a symbol 412 represents an AlₓGa₁₋ₓAs layer (clad layer); a symbol 413 represents a first electroconductive type Al_{y}Ga_{1-y}As layer (active layer); a symbol 414 represents a second electroconductive type Al_{z}Ga_{1-z}As layer (clad layer); and a symbol 415 represents a second electroconductive side GaAs layer (contact layer). Here, at least it is desired that y<x, and y<z. Further, a symbol 416 represents an interlayer insulative film such as SiN film; a symbol 417 represents a second electroconductive side electrode; and a symbol 418 represents a first electroconductive side electrode.

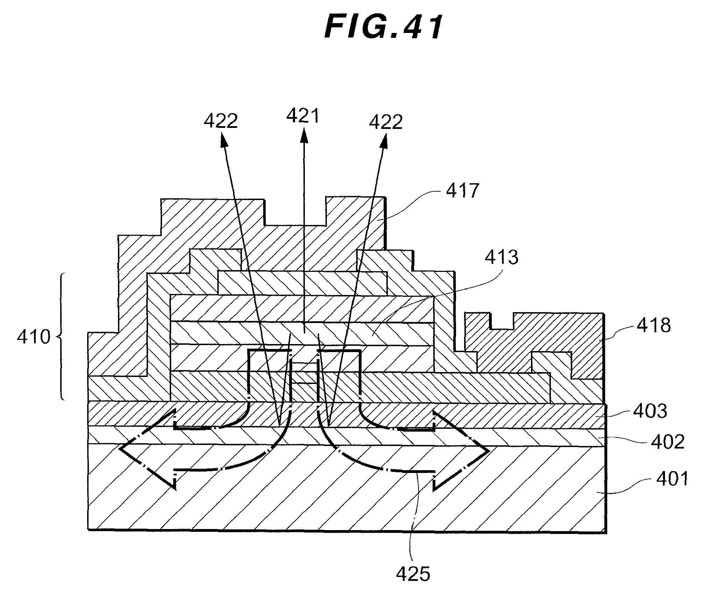

Fig. 41 is a diagram for explaining a heat conduction of LED device in embodiment 2 of the present invention.

The LED thin film element 410 emits light at the active layer 413 through supplying a voltage between the first electroconductive side electrode 418 and the second electroconductive side electrode 417 so as to make electricity flow. Light emitted toward bottom surface arrives at the metal layer 402, reflects on the surface of the metal layer 402 and is outputted from the surface side of light emitting element.

The heat produced with light emitting operation is conducted to the diamond-like carbon layer 403 with high heat conductivity, further is conducted to the metal layer 402, finally is conducted to the metallic substrate 401 with high heat conductivity, then is diffused toward external. In the drawing, such heat conduction operation is shown in a similar means, symbols 421~422 represent reflection of light, and a symbol 425 represents heat conduction.

### Explanation of effect:

As explained above, according to the embodiment 2, because a metal layer with high light reflectance is furnished on a metallic substrate 401 with high heat conductivity and a diamond-like carbon layer is further furnished on the metal layer, the light emitted toward a back side of the LED element reflects on the surface of the metallic substrate with high light reflectance and is outputted from the surface. Therefore, not only it is possible to obtain effect in embodiment 1, but also it is possible to obtain a light emitting element with high light reflectance.

### Explanation of transformation example:

In the embodiment 2, the diamond-like carbon layer is furnished between the LED thin film layer and the metallic substrate, however, as the embodiment 1, instead of the diamond-like carbon layer, a diamond layer can be adopted. Furthermore, the surface of the metal layer may be polished by a CMP (Chemical mechanical Polishing) method or the like so as to obtain a flat surface. Furthermore, instead of the diamond-like carbon layer, such thin film with high heat conductivity as diamond layer, silicon carbide (SiC), AlN layer, oxidized aluminum (Al₂O₃) or the like.

### <Embodiment 3>

In the embodiment, as compared with the structure of the embodiments 1 and 2, a semiconductor thin film is furnished on a freestanding substrate of diamond-like carbon so as to more improve heat liberating effect.

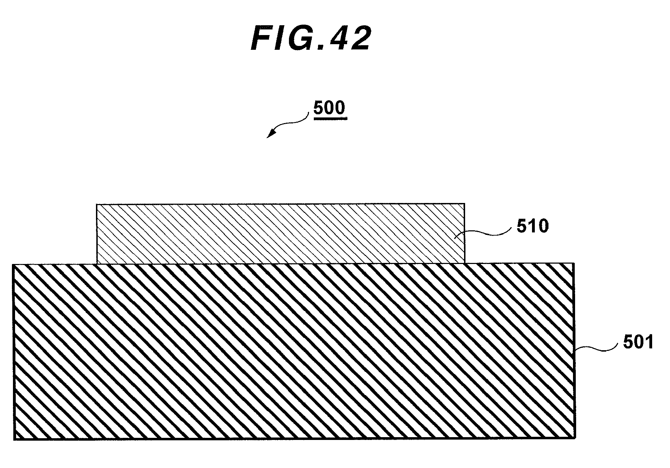

Fig. 42 is a cross section showing a semiconductor device in embodiment 3 of the present invention.

As shown by the Fig. 39, a symbol 501 represents a diamond-like carbon substrate. Regarding a surface flatness of the diamond-like carbon substrate, it is desired such as that in embodiment 1. That is, the average value of surface roughness Ra≤5nm, the maximum roughness RPV≤10nm, the maximum undulation Rmax≤1/1000, best is that the average value of surface roughness Ra≤3nm, the maximum roughness RPV≤5nm.

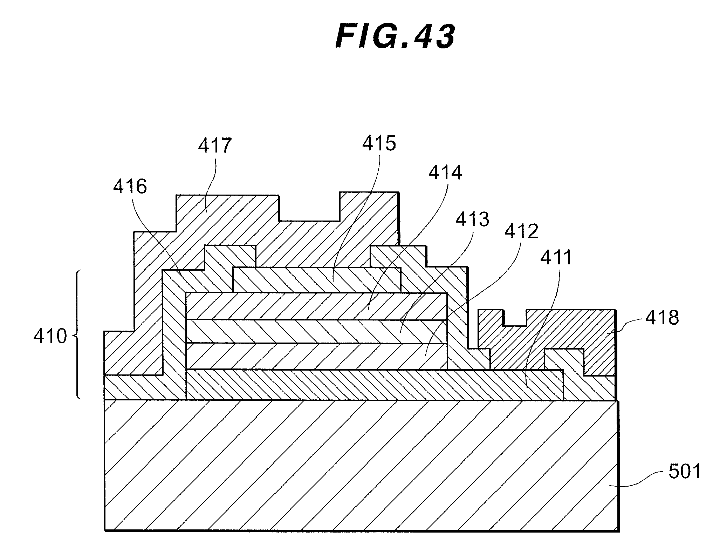

Fig. 43 is a cross section showing a LED element in embodiment 3 of the present invention.

The Fig. 43 shows a concrete example of the semiconductor thin film layer 510 of the embodiment 3. As shown by the Fig. 43, a LED element 450 of the embodiment 3 adopts a structure to bond the LED thin film element 410 (Fig. 40) of the embodiment 2 onto the diamond-like carbon substrate 501. Regarding the LED thin film element 410, here, its explanation is omitted. However, the present invention is not limited in such semiconductor layer structure. It is possible to adopt various transformation examples, that is, such structure also can be applied to these conformations of semiconductor element in embodiment 1.

The LED element 450 performs the same operation as the LED element 400 (Fig. 40). In the LED element 450, the heat produced with light emitting operation of light emitting element is conducted to the diamond-like carbon substrate 501. Because the diamond-like carbon substrate 501 has high heat conductivity, the heat is efficiently liberated toward external.

### Explanation of effect:

As explained above, according to the embodiment 3, because the LED thin film layer (an example of semiconductor thin film) is directly bonded on the diamond-like carbon substrate 501 by intermolecular interaction, even if using these semiconductor materials whose lattice constants are different, it is possible to keep a high quality without crystal defect, and to obtain a high heat conduction.

### Explanation of transformation example:

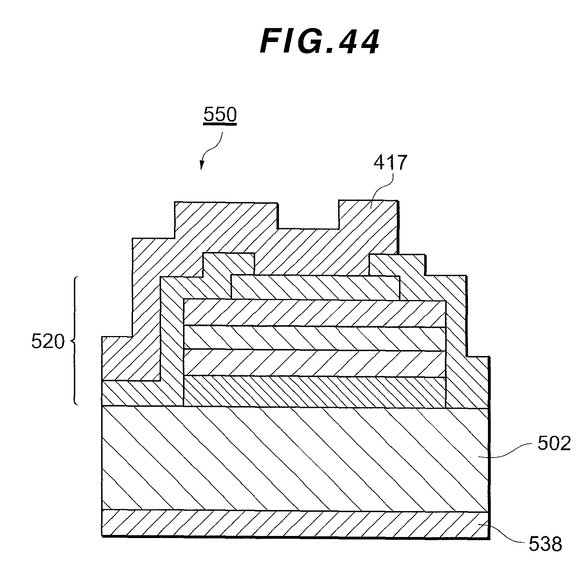

Fig. 44 is a cross section showing a LED element in a transformation example of embodiment 3 of the present invention.

As shown by the Fig. 44, a LED element 550 in an transformation example of the embodiment 3 is formed through replacing the diamond-like carbon substrate 501 (Fig. 43) in the LED element 450 (Fig. 43) of the embodiment 3 with an electroconductive diamond-like carbon substrate 502 and through using metal to furnish a first electroconductive side electrode 538 on bottom surface. Thus, as compared with the embodiment 3, it is possible to obtain better effect. Here, when supplying electrical conductivity to the diamond-like carbon, through increasing, for example, graphite ingredient, it is possible to heighten the electrical conductivity. In the case, it is necessary to select film forming condition for increasing the graphite ingredient. Further, instead of the diamond-like carbon substrate, it is possible to adopt diamond substrate.

### <Embodiment 4>

In the embodiment, there is an objective to heighten heat conductivity in transverse direction through using metal layer to cover the surface of the diamond-like carbon substrate used in embodiment 3.

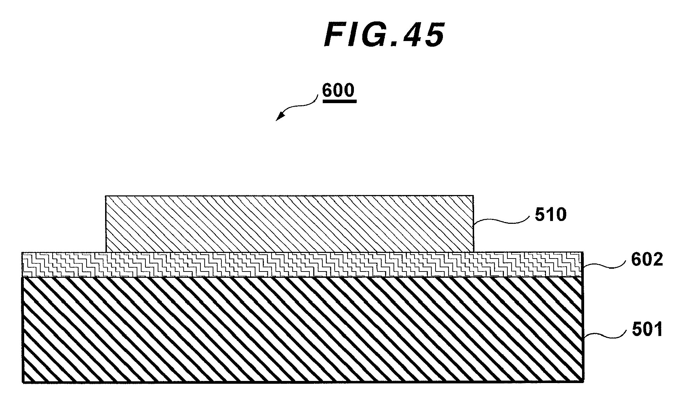

Fig. 45 is a cross section showing a semiconductor device in embodiment 4 of the present invention.

As shown by the Fig. 45, a semiconductor device 600 of the embodiment 4 is different from a semiconductor device 500 (Fig. 42) of the embodiment 3 at the point that a metal layer 602 intervenes between the LED thin film layer 510 and the diamond-like carbon substrate 501. Here, as material of the metal layer 602, it can be selected from, for example, Cuprum, an alloy containing Cuprum, Aluminum, Aluminum/Nickel, Zinc, Nickel, Platinum, Gold, Silver, an alloy containing Gold, an alloy containing Silver, Titanium, Tantalum, Palladium, Iridium, Tungsten, an alloy containing Aluminum, AuGe/Ni, AuGeNi, and Ti/Pt/Au.

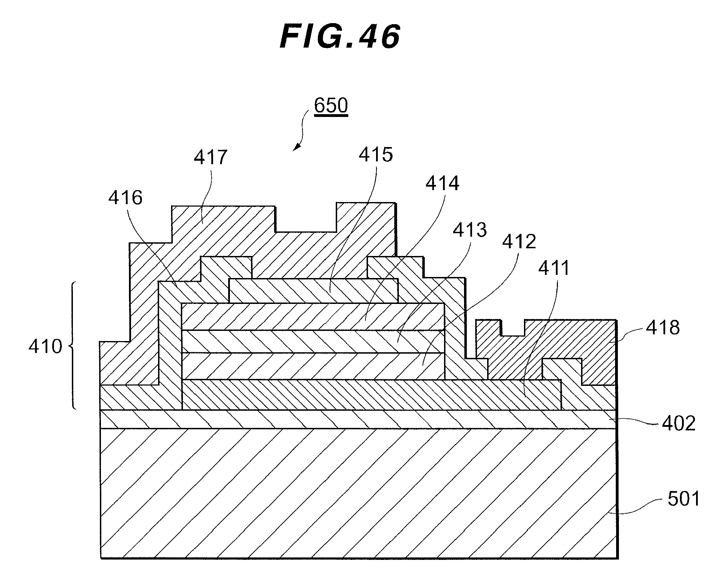

Fig. 46 is a cross section showing a LED element in embodiment 4 of the present invention.

The Fig. 46 shows a concrete example of the semiconductor thin film layer 510 of the embodiment 4. As shown by the Fig. 46, a LED element 650 of the embodiment 4 adopts a structure to furnish the metal layer 602 between the LED thin film element 410 of the LED element 450 (Fig. 43) in embodiment 3 and the diamond-like carbon substrate 501. Because the structures of the LED thin film element 410 and electrodes are the same semiconductor epitaxial accumulative structure and the electrode structure as that in embodiment 3, their explanations are omitted.

The LED element 650 in the embodiment performs the same operation as the LED element 400 (Fig. 40) explained in embodiment 2. Then, a contact between the first electroconductive side GaAs layer 411 placed in the lowest layer position of the LED thin film element 410 containing light emitting element and the metal layer 602 may be an ohmic contact formed by combining the semiconductor material bonding to the metal layer of the semiconductor thin film and metal layer. In the case, it is possible to form a low resistance contact.

In the LED element 650, the heat produced with light emitting operation of light emitting element is conducted to the metal layer 602 and the diamond-like carbon substrate 501 that are contacting. Because the diamond-like carbon substrate 501 has high heat conductivity, the heat is efficiently liberated toward external. Further, because the metal layer 602 is furnished on the surface of the diamond-like carbon substrate 501, the heat conductivity in transverse direction can be heightened. So it is possible to more efficiently liberate the heat toward external.

### Explanation of effect:

As explained above, according to the embodiment 4, because a metal layer is furnished on the diamond-like carbon substrate so as to obtain a structure that at least the semiconductor thin film is stuck to the metal layer, not only it is possible to obtain effect in embodiment 3, but also it is possible to obtain such effect: a heat conductivity from semiconductor thin film to metal layer becomes efficient. Further, it is possible to obtain a low resistance through combining the metal layer and the semiconductor layer bonding to the metal layer.

### Explanation of transformation example:

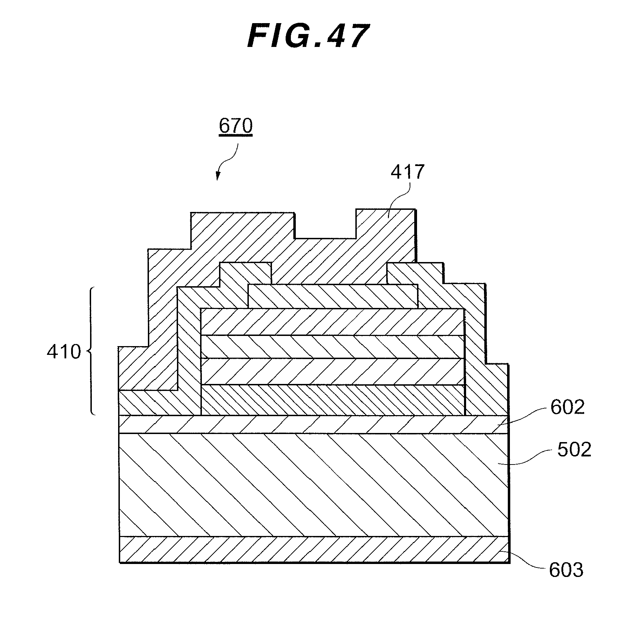

Fig. 47 is a cross section showing a LED element in a transformation example of embodiment 4 of the present invention.

As shown by the Fig. 47, a LED element 670 in an transformation example of the embodiment 4 is formed through replacing the diamond-like carbon substrate 501 (Fig. 46) in the LED element 650 (Fig. 46) of the embodiment 4 with an electroconductive diamond-like carbon substrate 502 and through using metal to furnish a first electroconductive side electrode 603 on bottom surface. Thus, as compared with the embodiment 4, it is possible to obtain better effect. Here, when supplying electrical conductivity to the diamond-like carbon, because the electrical conductivity changes according to different making method, through doping impurity such as nitrogen, silicon, phosphorus, metal or the like, it is possible to improve conductivity.

### <Embodiment 5>

In the embodiment, there is an objective to heighten light reflectance together with heightening heat conductivity through further furnishing a diamond-like carbon layer onto the metal layer 602 (Fig. 45) in embodiment 4.

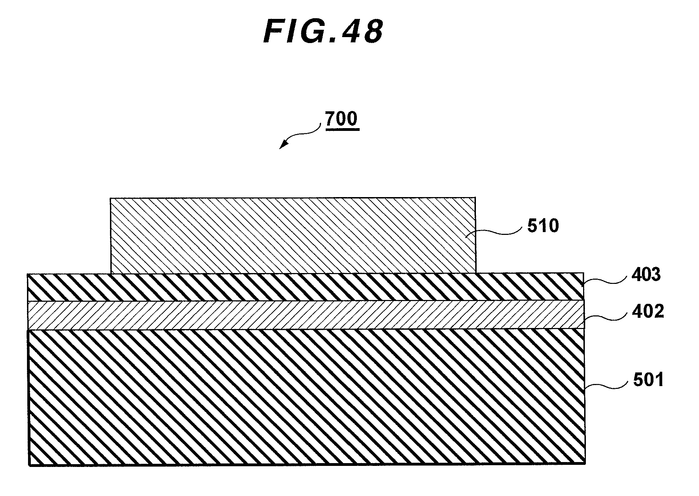

Fig. 48 is a cross section showing a semiconductor device in embodiment 5 of the present invention.

As shown by the Fig. 48, a symbol 501 represents a diamond-like carbon substrate; a symbol 402 represents a metal layer; a symbol 403 represents a diamond-like carbon layer; and a symbol 510 represents a LED thin film layer (an example of semiconductor thin film). Regarding a surface flatness of the metal layer 402, it is desired such as that in embodiment 1. That is, the average value of surface roughness Ra≤5nm, the maximum roughness RPV≤10nm, the maximum undulation Rmax≤1/1000. Regarding a surface flatness of the diamond-like carbon layer 403, it is also desired that the average value of surface roughness Ra≤5nm, the maximum roughness RPV≤10nm, the maximum undulation Rmax≤1/1000, best is that the average value of surface roughness Ra≤3nm, the maximum roughness RPV≤5nm, the maximum undulation Rmax≤1/1000. The LED thin film layer 510 is bonded onto the diamond-like carbon layer 403 by intermolecular interaction.

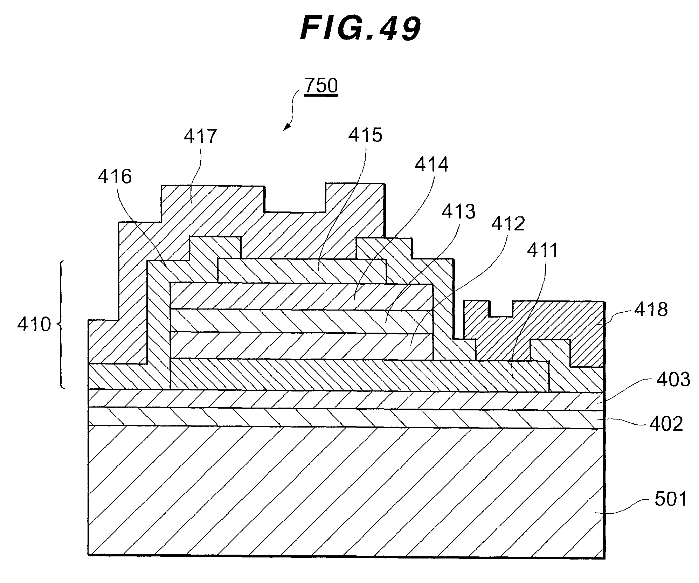

Fig. 49 is a cross section showing a LED element in embodiment 5 of the present invention.

As shown by the Fig. 49, in an accumulative structure of a LED element 750 of the embodiment, as compared with the LED element 400 (Fig. 40) in embodiment 2, except that the metallic substrate 401 (Fig. 40) is replaced with the diamond-like carbon substrate 501, other parts are the same as that in the LED element 400 (Fig. 40). Therefore, their explanations are omitted.

The diamond-like carbon layer 403 functions to conduct the heat produced with light emitting operation of light emitting element, together with serving as a bonding boundary surface controlling layer used for bonding the LED thin film layer 510. The metal layer 402 functions to serve as a light reflection layer for reflecting the light from the light emitting element, together with promoting heat conduction in transverse direction. Therefore, in the case that the metal layer 402 serves as a most upper layer to adopt material such as Au, Pt, Pd or the like, the metal layer 402 can function better. It is also possible to use metal material with high heat conductivity, such as Cu kind or Al kind to form a foundation.

### Explanation of effect:

As explained above, according to the embodiment 5, because an accumulative structure of metal layer and diamond-like carbon layer is furnished between a diamond-like carbon substrate and a LED thin film layer, it is possible to obtain, not only high light reflectance but also high heat conductivity. Further, it is possible to obtain a smooth boundary surface between the LED thin film layer and the diamond-like carbon substrate so as to obtain a strong bonding force.

Moreover, instead of the diamond-like carbon layer, diamond layer, SiC layer, Al₂O₃ layer or the like can be adopted.

### <Embodiment 6>

In the embodiment, there is an objective to heighten heat conductivity and prevent temperature rise through adopting SiC substrate and accumulating a metal layer and a diamond-like carbon layer on the SiC substrate.

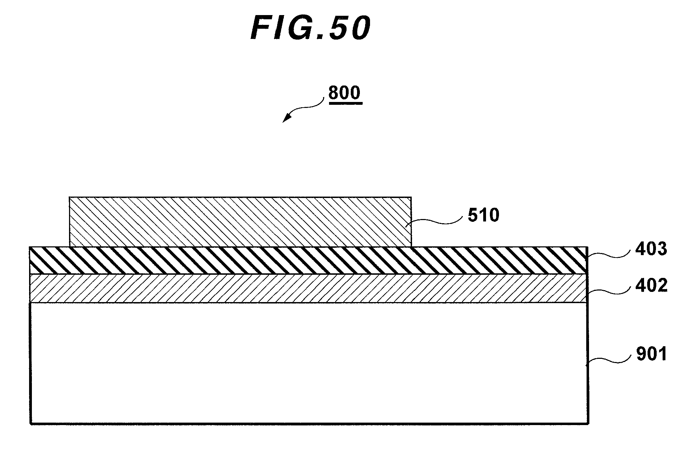

Fig. 50 is a cross section showing a semiconductor device in embodiment 6 of the present invention.

As shown by the Fig. 50, a symbol 901 represents a SiC substrate; a symbol 402 represents a metal layer; a symbol 403 represents a diamond-like carbon layer; and a symbol 510 represents a LED thin film layer (an example of semiconductor thin film).

The SiC substrate 901 is, for example, a cubic crystal SiC (3C-SiC). It also may be single crystal. Further, it may be a mix of these crystals and other crystal such as six sides cube and the like. Regarding a surface flatness of the SiC substrate 901, it is at least desired that the average value of surface roughness Ra≤5nm, the maximum roughness RPV≤10nm, the maximum undulation Rmax≤1/1000, best is that the average value of surface roughness Ra≤3nm, the maximum roughness RPV≤5nm, the maximum undulation Rmax≤1/1000.

The metal layer 402 is a metal layer which at least has a reflectance being 50% or over with respect to at least one light with a wavelength band within 350nm~1500nm. As a material of the metal layer 402, it is, for example, Cuprum, an alloy containing Cuprum, Aluminum, Aluminum/Nickel, Zinc, Nickel, Platinum, Gold, Silver, an alloy containing Gold, an alloy containing Silver, Titanium, Tantalum, Palladium, Iridium, Tungsten or the like. The metal layer 402 may be a single layer, also may be an accumulated layer. In the case that the metal layer 402 is an accumulated layer, it is desired that a most upper layer in the metal layer 402 has a high reflectance. The metal layer 402 can be formed by, for example, sputtering method.

The diamond-like carbon layer 403 can be set to have the above-stated flatness. As the embodiment 1, the diamond-like carbon layer 403 can be formed by plasma CVD (Chemical Vapor Deposition) method or ion plating method or the like.

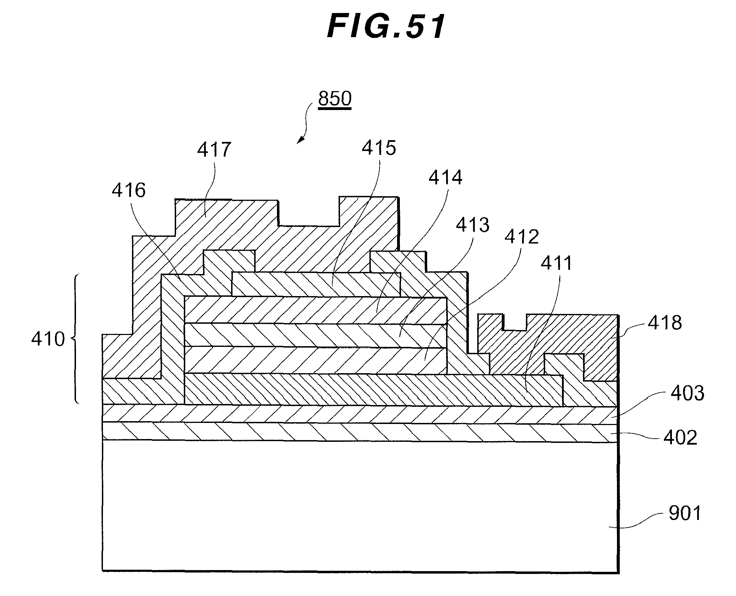

Fig. 51 is a cross section showing a LED element in embodiment 6 of the present invention.

As shown by the Fig. 51, in an accumulative structure of a LED element 850 of the embodiment, as compared with the LED element 400 (Fig. 40) in embodiment 2, except that the metallic substrate 401 (Fig. 40) is replaced with the SiC substrate 901, other parts are the same as that in the LED element 400 (Fig. 40). Therefore, their explanations are omitted.

The SiC substrate 901 functions as a substrate with high heat conductivity. The SiC substrate 901 has the same high heat conductivity as cuprum. In the case light emitting element exists, the metal layer 402 acts as a reflection layer to efficiently reflect light emitted toward bottom surface. The diamond-like carbon layer 403 acts as an insulative layer to separate the LED thin film layer 510 and the metal layer 402 and acts as a high heat conductive layer.

### Explanation of effect:

As explained above, according to the embodiment 6, because a SiC substrate 901 is adopted and a metal layer and a diamond-like carbon layer are furnished on the SiC substrate, it is possible to prevent temperature rise due to high heat conduction. Therefore, it is possible to realize stable characteristic and improve reliability. Further, not only it is possible to improve the characteristic of light emitting element through the metal layer efficiently reflects light, but also it is possible to improve processing performance of substrate and a resistance to processing liquid.

### <Embodiment 7>

In the embodiment, there is an objective to simplify an accumulative layer structure through removing the diamond-like carbon layer from the accumulative layer structure of the embodiment 6 and furnishing a common electrode of the semiconductor element on substrate side.

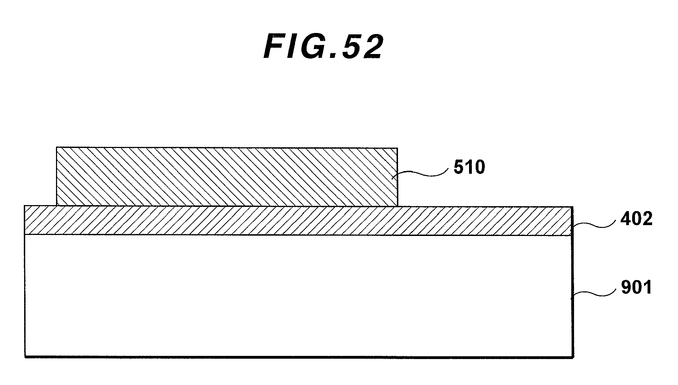

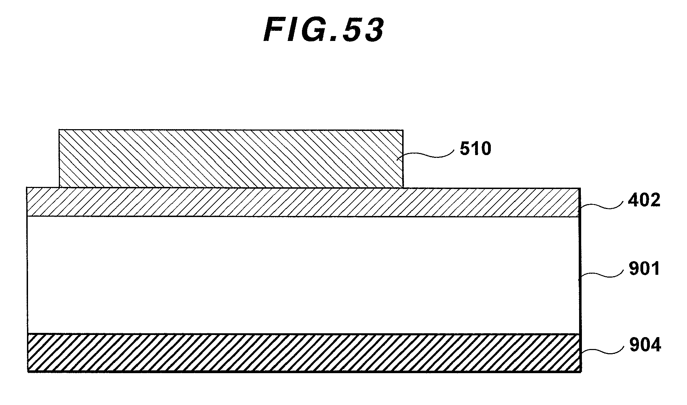

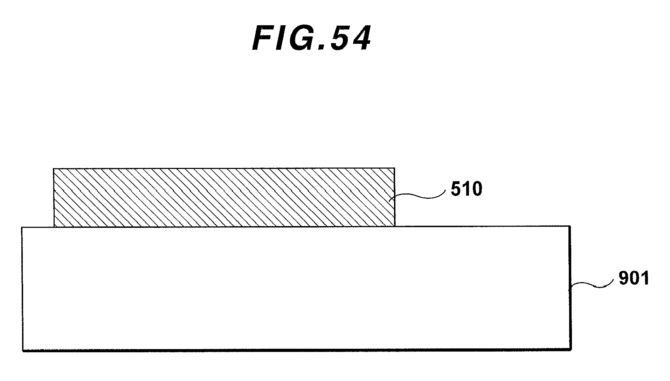

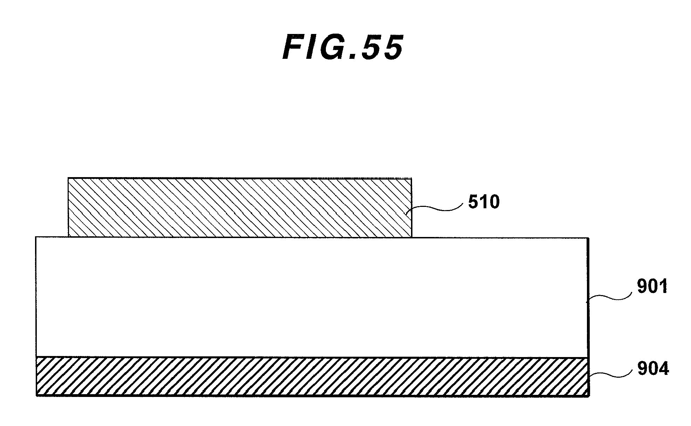

Fig. 52 is a first cross section showing a semiconductor device in embodiment 7 of the present invention; Fig. 53 is a second cross section showing a semiconductor device in embodiment 7 of the present invention; Fig. 54 is a third cross section showing a semiconductor device in embodiment 7 of the present invention; and Fig. 55 is a fourth cross section showing a semiconductor device in embodiment 7 of the present invention

As shown by these drawings, a symbol 901 represents a SiC substrate; a symbol 402 represents a metal layer; a symbol 904 represents a metal film; and a symbol 510 represents a LED thin film layer (an example of semiconductor thin film).

Whole of the LED thin film layer 510 (an example of semiconductor thin film) is sticking to the metal layer 402 or the SiC substrate 901. The SiC substrate 901 is better to have high resistance and electroconductivity, it can be suitably selected by operation design of element comprised by semiconductor thin film.

With respect to the metal layer 402, it is possible to select suitable material according to request specification of contact resistance between the metal layer 402 and the LED thin film layer 510 (an example of semiconductor thin film) contacting with the metal layer 402, light reflectance of metal layer surface or the like. For example, in the case to need low contact resistance, it is possible to adopt such metal as Ni, Ni/Al, Pd, AuGe/Ni, AuGeNi and the like, as proposed material; in the case to need high reflectance, it is possible to adopt such metal as Au, Pd, Pt and the like, as proposed material. Also it is possible to apply metal material layer stated in embodiment 2 to the embodiment 7.

In the conformation to set low contact resistance of the metal layer 402 and the LED thin film layer 510 (an example of semiconductor thin film), through adopting the SiC substrate 901 as electrical conductive substrate, the SiC substrate 901 operates as electroconductive layer. In the case, as shown by the Fig. 53, through furnishing a separated metal film 904 on the bottom surface of the SiC substrate 901, it is possible to furnish a common electrode of semiconductor element on the bottom surface of the substrate. The SiC substrate 901 may be low resistance substrate of p type or n type, and such conformation also can be adopted to remove the metal layer so as to directly bond the semiconductor thin film onto the SiC substrate 901 as shown by the Figs. 54∼55.

### Explanation of effect:

As explained above, according to the embodiment 7, because a SiC substrate 901 is adopted and a semiconductor thin film (i.e. LED thin film, an example of semiconductor thin film) is bonded on surface of a metal layer furnished on SiC substrate or on surface of the SiC substrate, it is possible to furnish a common electrode of semiconductor element comprised by LED thin film layer (an example of semiconductor thin film) on the side of substrate. Therefore, it is possible to simplify the accumulative layer structure.

Moreover, in the embodiments 1~7, as a concrete example of semiconductor element comprising LED thin film layer, a semiconductor accumulative layer structure to construct a light emitting diode is explained. However, the present invention is not limited in these embodiments. The present invention can be applied to other semiconductor accumulative layer structure to construct various kinds of semiconductor elements. Further, the semiconductor element comprised by LED thin film layer is not limited in one kind, it is possible to mix plural kinds of semiconductor elements. Furthermore, the number of elements is not restricted. Moreover, in the explanation of above-stated embodiments, as the semiconductor material, it is to adopt inorganic semiconductor material. However, even if the semiconductor thin film element used organic semiconductor material, it is possible to obtain heat liberating effect while element is operating.

### <Embodiment 8>

In the embodiment, a light emitting element array is formed by using the light emitting element explained in embodiments 1~7. In a structure that will be explained below, light emitting elements are arranged in one dimension, and a driving circuit to drive a light emitting element array is furnished on a substrate.

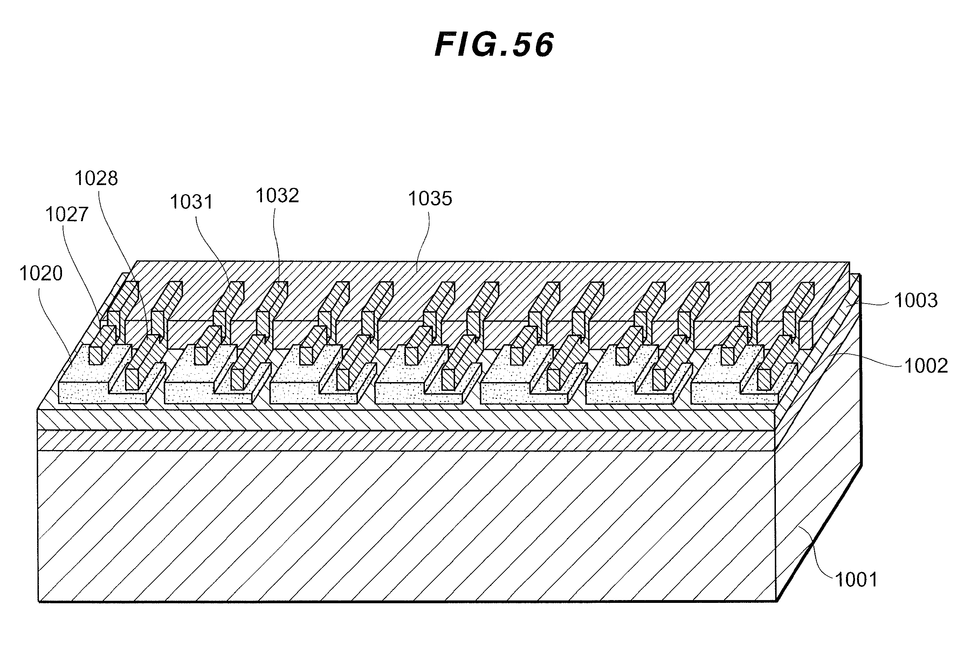

Fig. 56 is a cubic diagram showing a light emitting element array in embodiment 8 of the present invention.

As shown by the Fig. 56, a light emitting element array comprises a SiC substrate 1001, a metal layer 1002 formed on the SiC substrate 1001, and a diamond-like carbon layer 1003. The SiC substrate 1001, the metal layer 1002 and the diamond-like carbon layer 1003 are the same as that explained above in embodiments 1~7.

Further, there is a light emitting diode 1020. as an example, the light emitting diode 1020 has the same semiconductor accumulative layer structure as the LED thin film element 41 (Fig. 49) explained in embodiment 5. In the Fig. 56, an interlayer insulative film is omitted, which is used for preventing a short between first electroconductive side and second electroconductive side, i.e. between electrode and semiconductor layer or between electrode wirings. Furthermore, there are a second electroconductive side electrode 1027 and a first electroconductive side electrode 1028. The second electroconductive side electrode 1027 and the first electroconductive side electrode 1028 are the same as the second electroconductive side electrode 417 (Fig. 49) and first electroconductive side electrode 418 (Fig. 49) of the LED element 750 explained in embodiment 5, not only in structure, but also in material.

Further, there are a second electroconductive side wiring 1031, a first electroconductive side wiring 1032 and a driving circuit 1035 for driving the light emitting diode 1020. The driving circuit 1035 is an integrated circuit of thin film transistor mainly using inorganic material such as amorphous Si, polycrystalline Si, ZnO or the like; or is an integrated circuit of thin film transistor mainly using organic material. The light emitting diode 1020 and the driving circuit 1035 are connected by the second electroconductive side wiring 1031 and the first electroconductive side wiring 1032.

Regarding their connection form with wiring of input of power source or signal toward the driving circuit 1035 or with external circuit, their explanation is omitted. In the drawing, the light emitting diode 1020 is separated per element. However, regarding an element separation form, a connection with the driving circuit 1035, a drive form such as an associative drive form of all light emitting diodes 1020, time separation drive form or the like, they may be suitably designed and may be transformed into various kinds. Further, regarding the number, pitch, size, array form (one straight line, zigzag arrangement), and the like of the light emitting elements, they also may be transformed into various kinds. Furthermore, regarding drive function of the driving circuit 1035, it may be designed into various kinds. The present invention is not limited in any form.

In the present invention, the SiC substrate 1001, the diamond-like carbon layer 1003, and the metal layer 1002 perform action so as to efficiently conduct and liberate heat produced while the light emitting diode 1020 operates to light lamp. The metal layer 1002 performs action so as to make light emitted from the light emitting diode 1020 toward substrate side come out from front surface (i.e. along a Y-axis direction in drawing). The driving circuit 1035 performs control so as to make the plural light emitting diodes 1020 execute desired lamp lighting operation. The light emitting diode 1020 perform lamp lighting operation, for example, to sequentially light lamp or to light lamps associatively (i.e. together), through using drive program set inside or through a drive signal from external, according to a desired design.

### Explanation of effect:

As explained above, according to the embodiment 6, because a metal layer is furnished on a SiC substrate, and a diamond-like carbon layer is furnished on the metal layer, then plural light emitting diode are arranged on the diamond-like carbon layer and a driving circuit to drive the plural light emitting diodes is furnished on the diamond-like carbon layer, it is possible to obtain a compact light emitting element array having excellent heat liberating performance, high characteristic and high reliability.

### Explanation of transformation example:

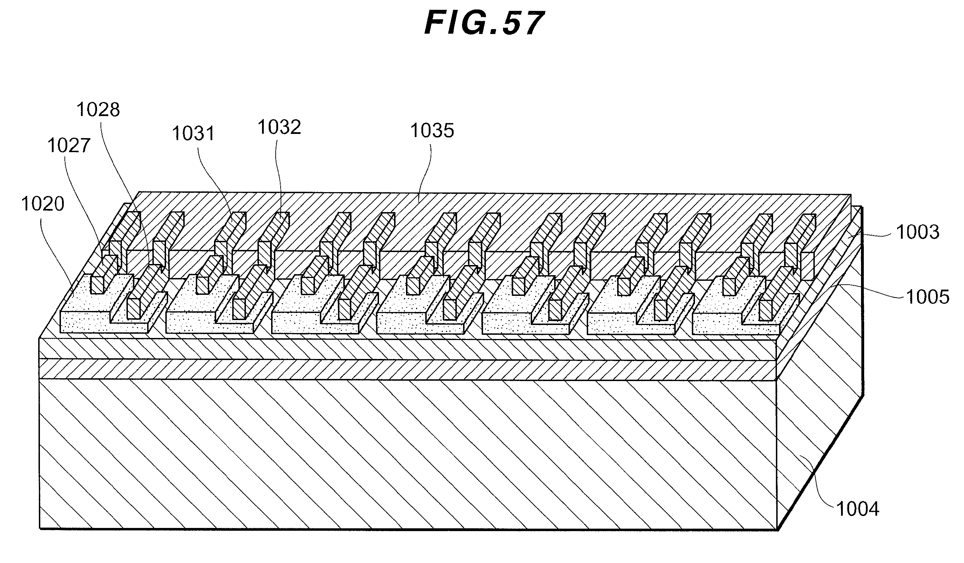

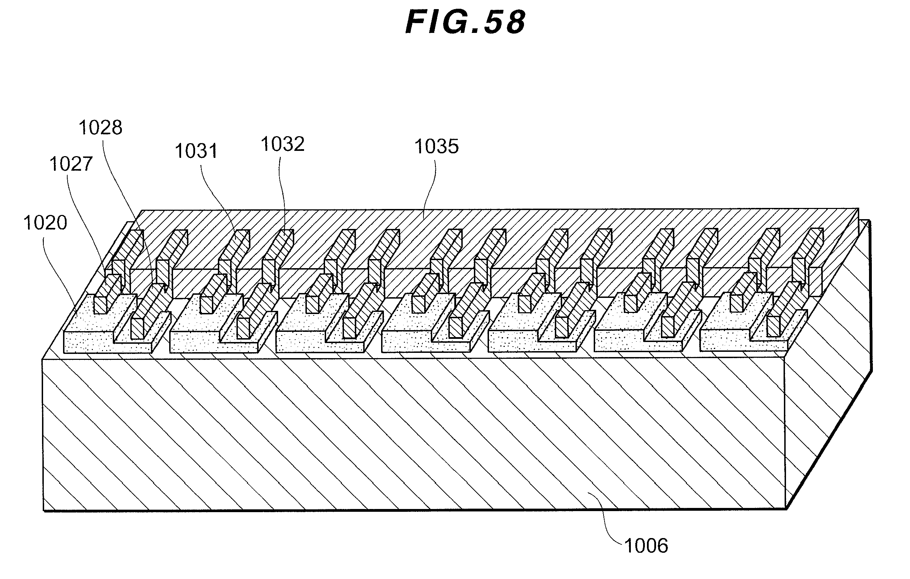

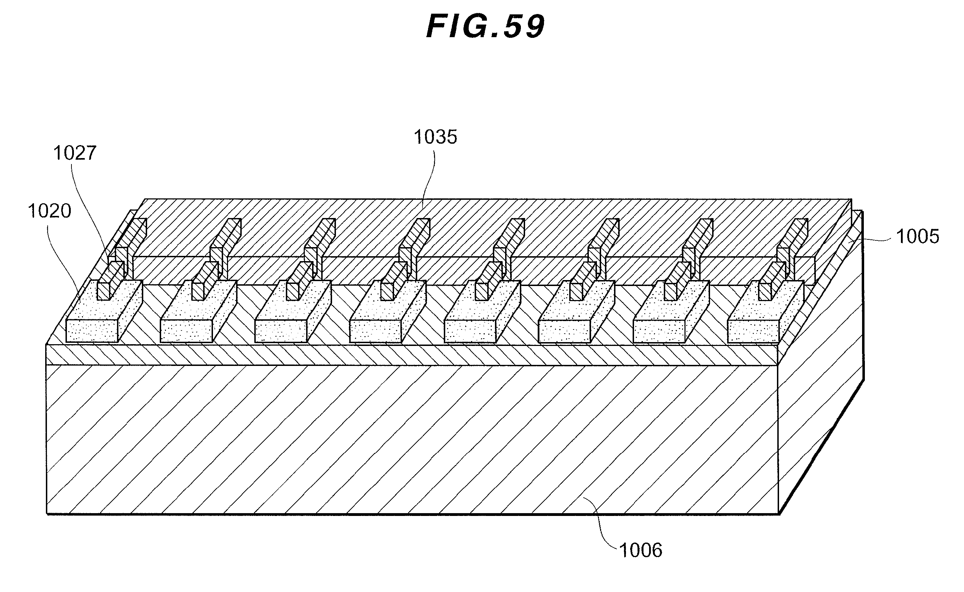

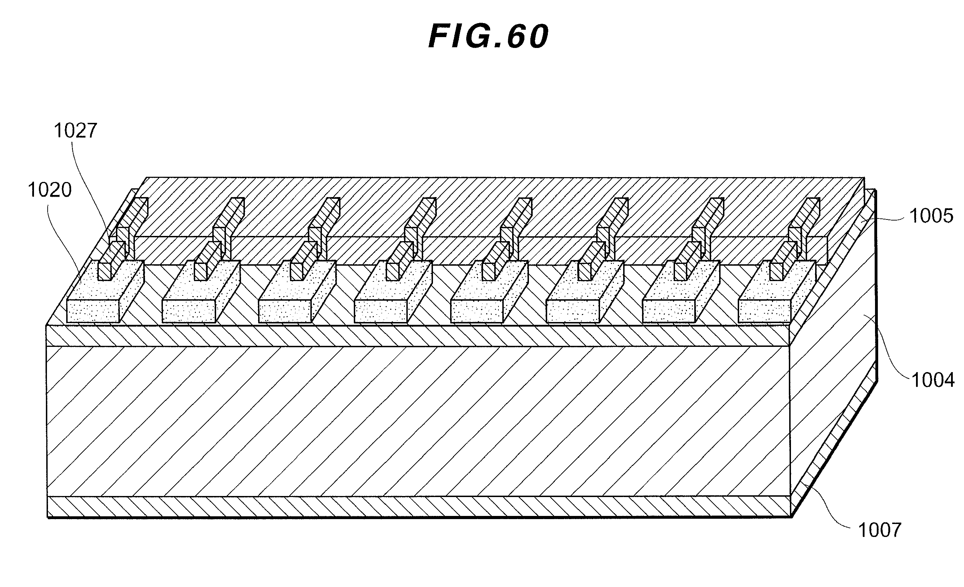

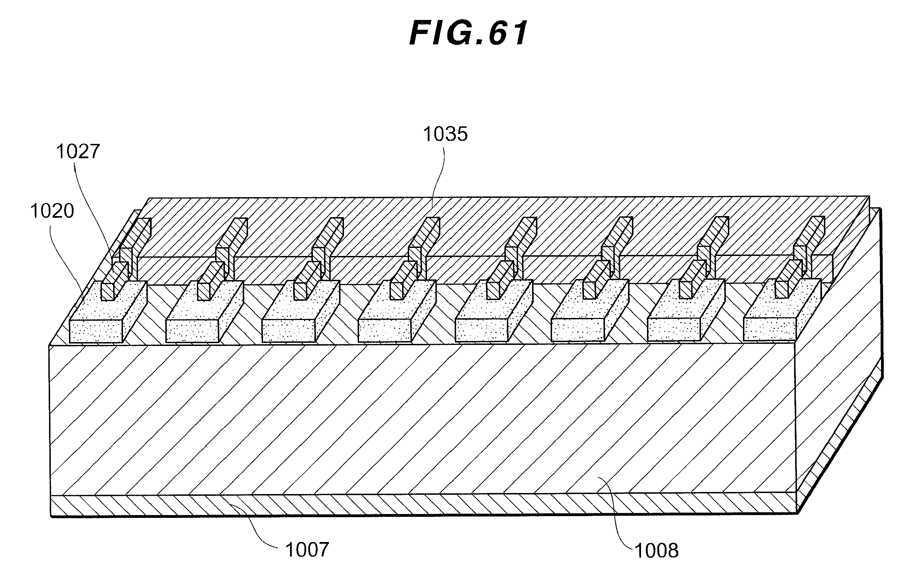

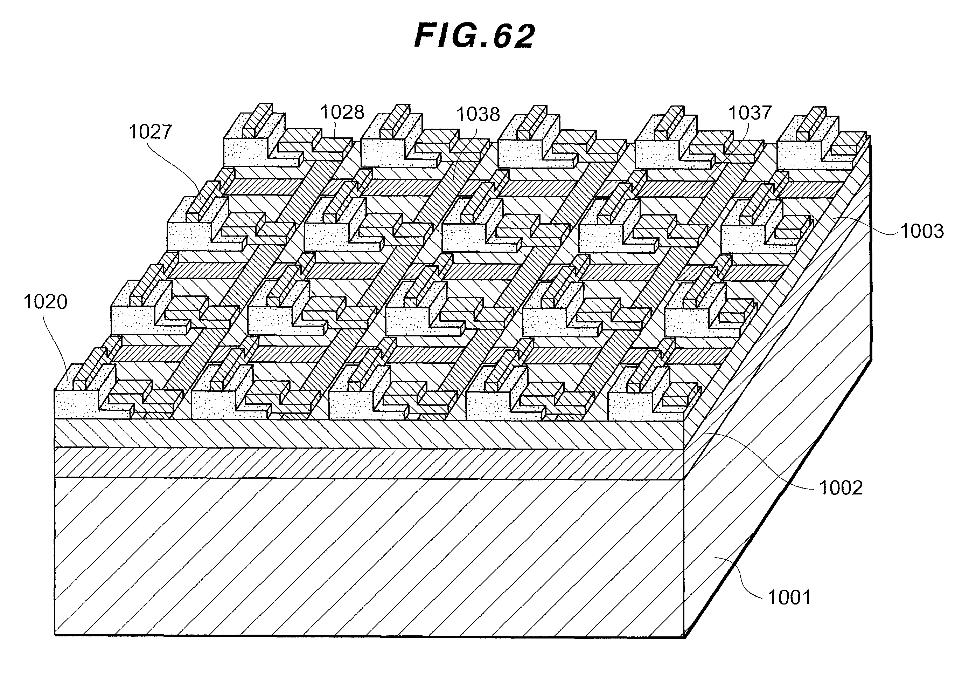

Fig. 57 is a first cubic diagram showing a transformation example of light emitting element array in embodiment 8 of the present invention; Fig. 58 is a second cubic diagram showing a transformation example of light emitting element array in embodiment 8 of the present invention; Fig. 59 is a third cubic diagram showing a transformation example of light emitting element array in embodiment 8 of the present invention; Fig. 60 is a fourth cubic diagram showing a transformation example of light emitting element array in embodiment 8 of the present invention; Fig. 61 is a fifth cubic diagram showing a transformation example of light emitting element array in embodiment 8 of the present invention; and Fig. 62 is a sixth cubic diagram showing a transformation example of light emitting element array in embodiment 8 of the present invention.

As shown by the Fig. 57, it is possible to replace the SiC substrate 1001 with a metal substrate 1004. As shown by the Fig. 58, as another transformation example, it is possible to replace the SiC substrate 1001 with a diamond-like carbon substrate 1006. As shown by the Figs. 59 and 60, it is possible to respectively furnish a metal layer 1005 and a metal layer 1007 on the upper surface and the bottom surface of the diamond-like carbon substrate. Further, as shown by the Fig. 61, it is possible to bond light emitting diode onto an electroconductive SiC substrate or onto an electroconductive diamond-like carbon substrate 1008 and to furnish a metal layer 1007 on the bottom surface of the substrate. Furthermore, instead of the diamond-like carbon layer and the diamond-like carbon substrate, diamond layer and the diamond substrate can be adopted. In the explanation of the above-stated embodiments, an arrangement of light emitting elements with one-dimension is described, but, as shown by the Fig. 62, an arrangement of light emitting elements with two-dimension can be adopted. Moreover, in the Fig. 62, there are a second electroconductive side wiring 1037 and a first electroconductive side wiring 1038.

### <Embodiment 9>

In the embodiment, there is an objective which is different from the embodiments 1~8 and is to attempt a labour-saving manufacturing process through using an AlN to cover substrate and furnishing a semiconductor element on the AIN.

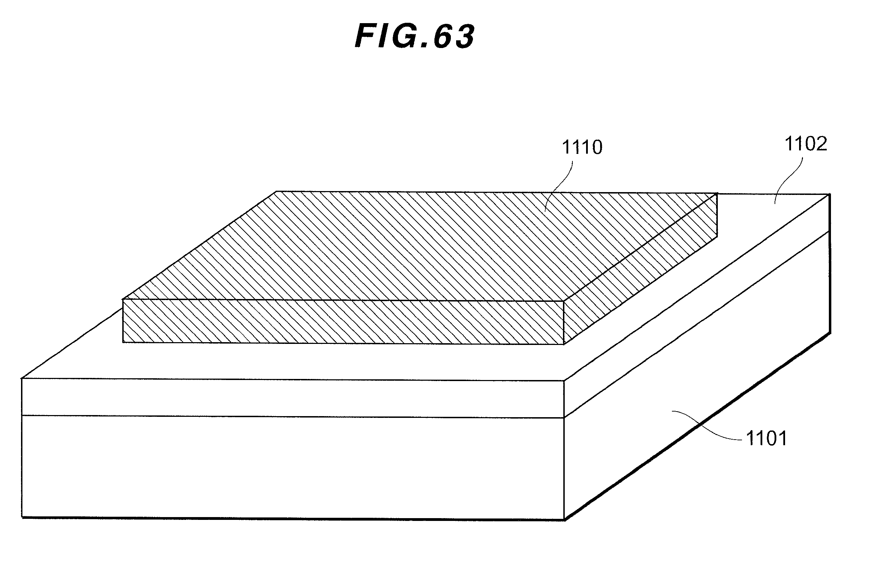

Fig. 63 is a cubic diagram showing a semiconductor device in embodiment 9 of the present invention.

As shown by the Fig. 63, there is a substrate 1101 such as a metal substrate, a diamond-like carbon substrate, a SiC substrate or the like. In the case that the substrate 1101 is a metal substrate, it is possible to adopt concrete material stated above in the embodiment 1. Regarding surface roughness and flatness of the substrate surface, they can be set in the same conditions as that in stated-above embodiments. Further, there is an AlN layer 1102, the AlN layer 1102 may be any of single crystal, multiple crystal and amorphous crystal.

The AlN layer 1102 can be formed by a method such as sputtering method, heat VD method, Plasma CVD (Chemical Vapor Deposition) method, OMCVD method, MBE (Molecular Beam Epitaxy) method or the like. The AlN layer 1102 can be in a grown-film state (as-deposit state). Further, it is possible to perform a surface process with respect to the AlN layer 1102 through polishing surface or CMP process. Regarding a surface flatness of the AlN layer 1102, it is desired that the average value of surface roughness Ra≤3nm, the maximum roughness RPV≤3nm, the maximum undulation Rmax≤1/1000. Furthermore, a semiconductor thin film 1110 is bonded onto the surface of the AlN layer 1102 through intermolecular interaction without using adhesive. As stated in the embodiments, a semiconductor element comprised by the semiconductor thin film 1110 may be all kinds of semiconductor element such as light emitting element, sensor, transistor circuit or the like.

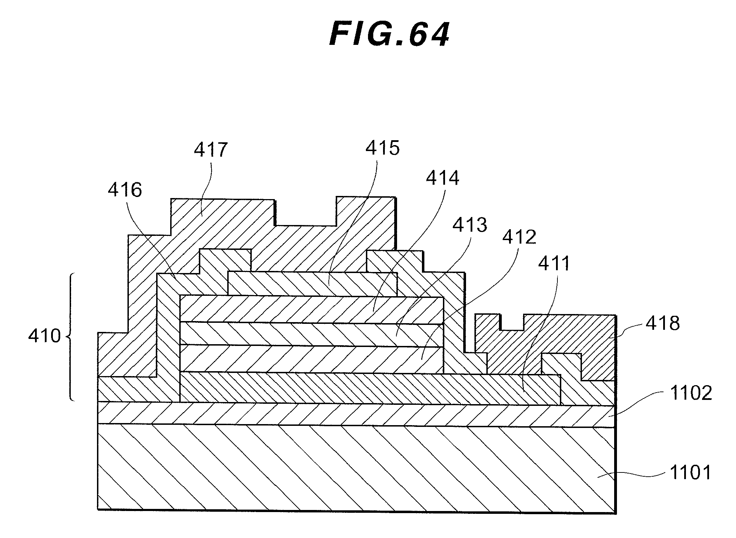

Fig. 64 is a cross section showing a LED element in embodiment 9 of the present invention.

The Fig. 64 shows a concrete example of a LED thin film element 410 in embodiment 2, in the concrete example, a light emitting diode is comprised and a LED thin film element 410 (Fig. 40) explained in the embodiment 2 is bonded on the substrate 1101/AlN layer 1102.

As the point of the embodiment 9, the AlN layer 1102 functions as a heat conduction layer. Also it functions as a flat bass layer for bonding. The heat is efficiently conducted from the semiconductor element to the AlN layer 1102, and is further conducted to the substrate placed below.

Explanation of effect:
As explained above, according to the embodiment 9, because a AlN layer 1102 is adopted and is furnished on a substrate 1101, not only it is possible to obtain effects of embodiments 1~8, but also it is possible to obtain such effect: because the AlN layer 1102, in particular, the AlN layer 1102 with multiple crystal or amorphous crystal formed by sputtering method, it is possible to obtain a labour-saving manufacturing process; further, as compared with diamond material, in the embodiment, a mechanical surface process such as polish, CMP can be easily performed.

### Explanation of transformation example:

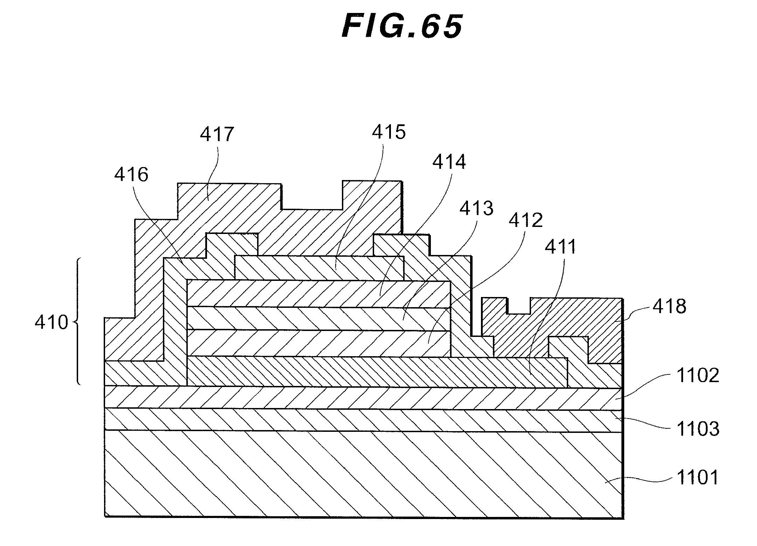

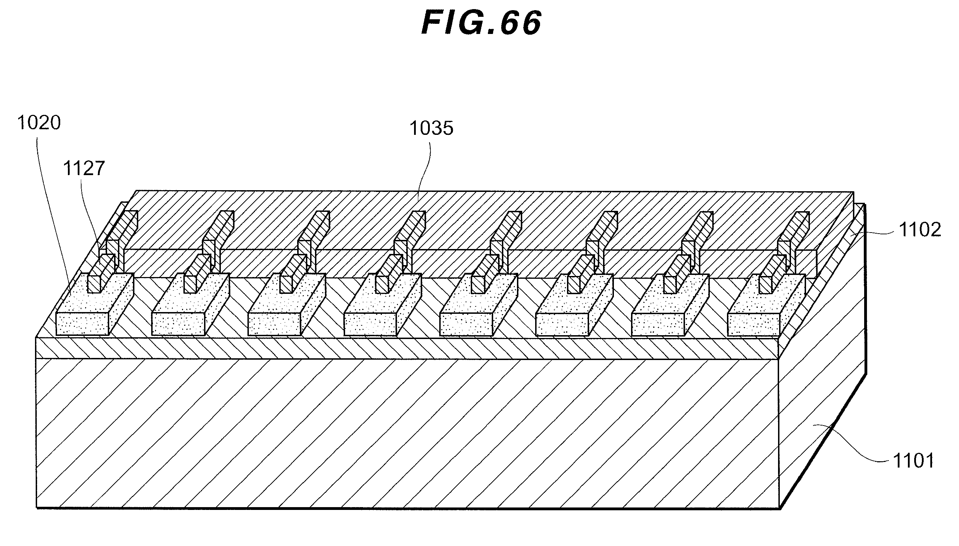

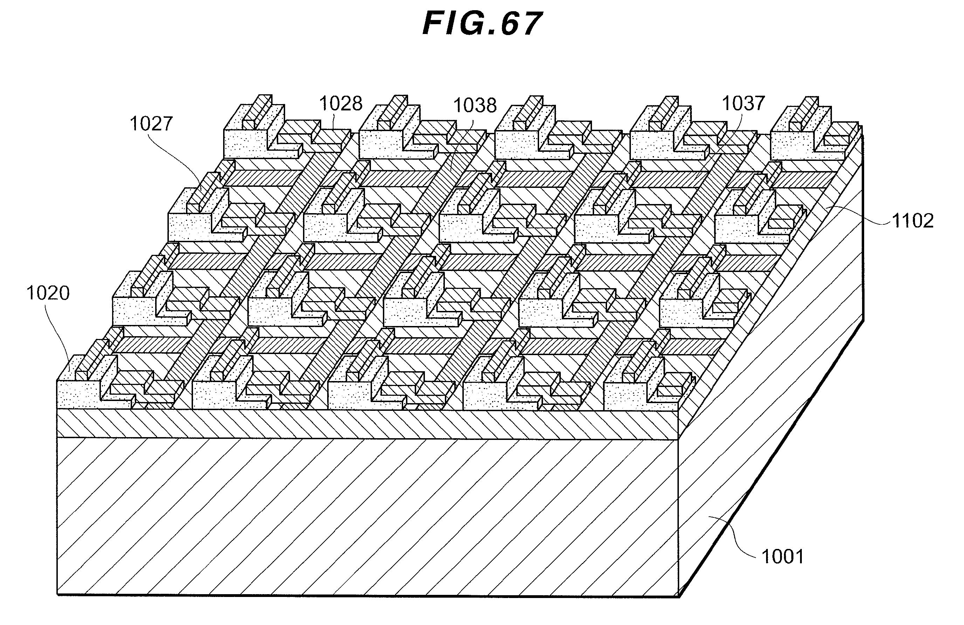

Fig. 65 is a cross section showing a LED element in another conformation of embodiment 9 of the present invention; Fig. 66 is a first cubic diagram showing a light emitting element array using LED element in embodiment 9 of the present invention; and Fig. 67 is a second cubic diagram showing a light emitting element array using LED element in embodiment 9 of the present invention.

The following is to explain example capable of being applied to various transformations stated in embodiment 1~8.

In the example shown by the Fig. 65, a second metal layer 1103 is furnished between the AlN layer 1102 and the substrate 1101. The second metal layer 1103 can adopt the same material as that stated in embodiment 2. In the example shown by the Fig. 66, the light emitting elements are arranged in a row. In the Fig. 66, 1020 represents light emitting diode (semiconductor thin film); 1035 represents a driving circuit for controlling the light emitting diode to light lamp, and 1127 represents connection wiring for connecting the light emitting diode with the driving circuit. In the example shown by the Fig. 67, the light emitting elements are arranged in two-dimension. In the Fig. 67, 1020 represents light emitting diode (semiconductor thin film); 1037 represents second electroconductive side wiring connected with second electroconductive side electrode 1027; and 1038 represents first electroconductive side wiring connected with first electroconductive side electrode 1028.

### <Embodiment 10>

In the embodiment, a LED head 1200 is formed by using LED element serving as semiconductor element explained in the embodiments 1~9.

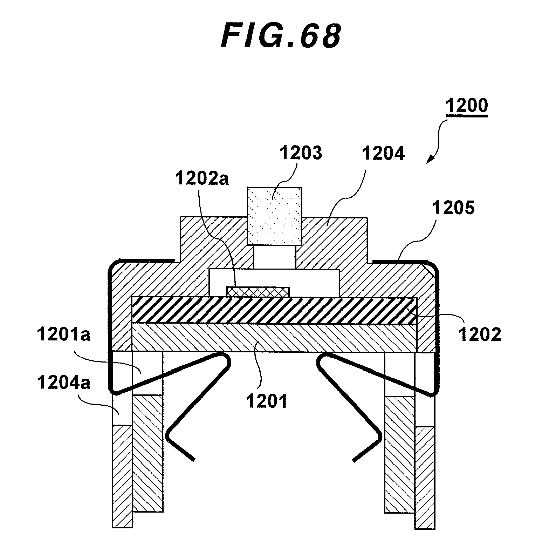

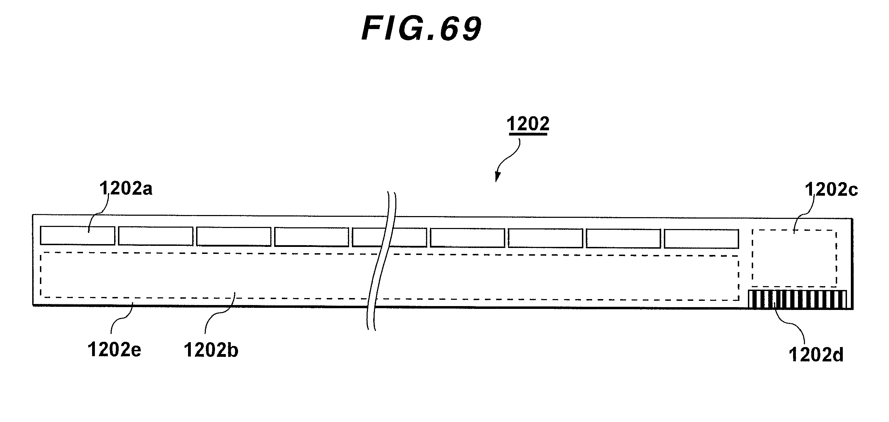

Fig. 68 is a cross section showing a LED head of the present invention; and Fig. 69 is a plane diagram showing a LED unit of the present invention.

As shown by the Figs. 68 and 69, on a base member 1201, a LED unit 1202 is carried. The LED unit 1202 is formed by carrying LED element that serves as one semiconductor element explained in embodiments 1∼9 on a mount substrate.

As shown by the Figs. 68 and 69, on a mount substrate 1202e, a semiconductor combination device combining a light emitting section and a driving section is plurally arranged along a length direction, as a light emitting unit 1202a. Further, on the mount substrate 1202e, electronic part mount areas 1202b and 1202c in which electronic part is arranged and wiring is formed if furnished; and a connector 1202d for supplying power source or control signal from external.

Over the light emitting section of the light emitting unit 1202a, a rod lens array 1203 is furnished as an optics element to collect light emitted from the light emitting section. The rod lens array 1203 is formed through arranging plural optical lenses with pillar shape along the light emitting sections arranged in straight line, and is kept in a predetermined position by a lens holder 1204 serving as an optical element holder.

The lens holder 1204 is formed so as to cover the base member 1201 and the LED unit 1202. Then, the base member 1201, the LED unit 1202 and the lens holder 1204 are held as one body through clamper 1205 which is placed via opening portions 1201a and 1204a respectively formed on the base member 1201 and the lens holder 1204. Therefore, the light emitted by the LED unit 1202 passes through the rod lens array 1203 and irradiates to a predetermined external member. The LED print head 1200 is used as exposing device of an electrophotographic printer, an electrophotographic copying apparatus or the like.

### Explanation of effect:

As stated above, according to the LED head of the embodiment 10, because the LED unit 1202 adopts semiconductor combination device explained in the embodiments 1~9, it is possible to supply a LED head with high quality and high reliability.

### <Embodiment 11>

In the embodiment, a LED head is formed by using LED array serving as semiconductor device explained in the embodiments 8~9.

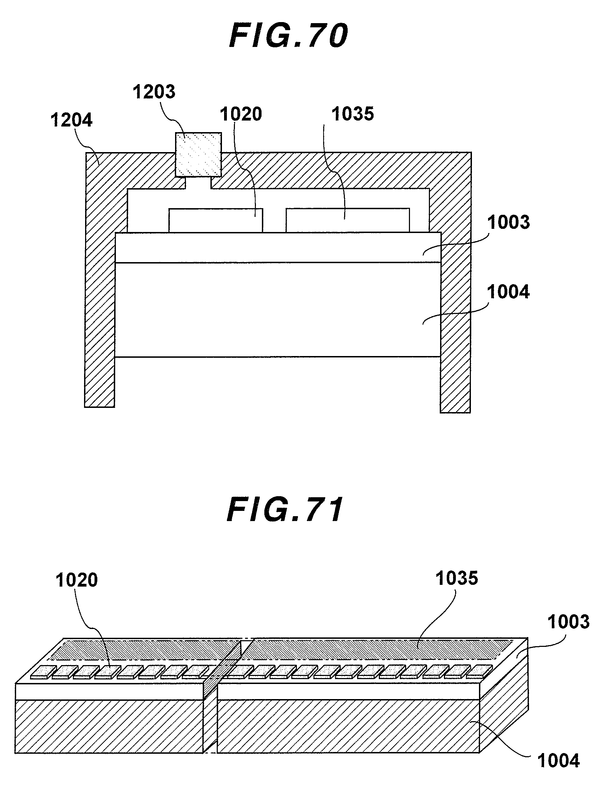

Fig. 70 is a cross section showing a LED head in embodiment 11 of the present invention; and Fig. 71 is a cubic diagram showing a LED head in embodiment 11 of the present invention.

As shown by the Figs. 70 and 71, there are a metal substrate 1004; a diamond-like carbon layer 1003; a LED film 1020 bonded on the diamond-like carbon layer 1003; a circuit group 1035 for driving LED furnished on the metal substrate 1004; a rod lens array 1203; and a lens holder 1204. On a width part of the metal substrate 1004, the LED film 1020 is bonded to correspond to a print width part.

Here, the LED unit is a conformation in which a metal layer 1005 in Fig. 57 is omitted. however, it is possible to adopt various kinds of transformation example as stated in embodiments 8∼9. Further, it is possible to add a substrate such as a metal substrate or the like to contact with the metal substrate 1004 under the metal substrate 1004 for liberating heat and supporting.

### Explanation of effect:

As stated above, according to the LED head of the embodiment 10, because the LED unit adopts semiconductor combination device explained in the embodiments 8~9, it is unnecessary to separately mount chip on mount substrate. Further, it is possible to supply a LED head with high liberating performance, high quality and high reliability.

### <Embodiment 12>

In the embodiment, an image forming apparatus is explained which is formed by using the LED head obtained in embodiment 10 or 11.

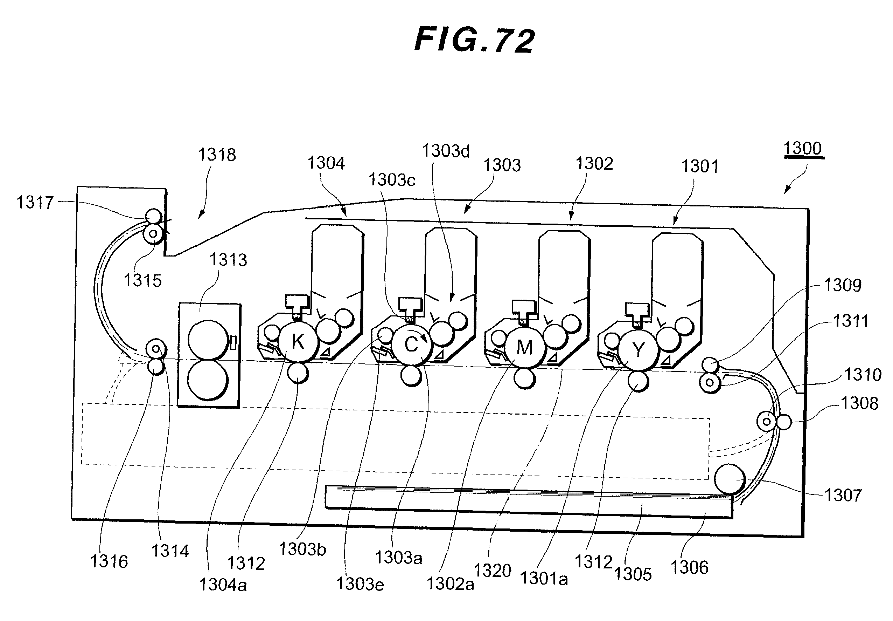

Fig. 72 is a cross section showing a main part of image forming apparatus of the present invention.

As shown by the Fig. 72, in an image forming apparatus 1300, four process units 1301∼1304 for forming images of respective colors of yellow, magenta, cyan, and black are sequentially arranged along a conveyance route 1320 of record medium 1305 from upstream side. Because the four process units 1301~1304 have the common internal structure, here, it is only to explain the process units 1303 of cyan, as an example.

In the process units 1303, a photosensitive drum 1303a is placed as an image carrying body and it can rotate along an arrow direction. Around the photosensitive drum 1303a, according to a sequence from upstream side in rotating direction, a charging device 1303b and an exposing device 1303c are arranged. The charging device 1303b is used for supplying electricity to the surface of the photosensitive drum 1303a and making the photosensitive drum 1303a be on charge; and the exposing device 1303c is used for selectively irradiate light on the surface of the photosensitive drum 1303a so as to form an electrostatic latent image on the surface of the photosensitive drum 1303a. Further, around the photosensitive drum 1303a, a developing device 1303d and a cleaning device 1303e are arranged. The developing device 1303d is used for making toner with predetermined color adhere to the surface of the photosensitive drum 1303a on which the electrostatic latent image has been formed so as to develop the electrostatic latent image; and the cleaning device 1303e is used for removing toner remaining on the surface of the photosensitive drum 1303a. Moreover, the drum or rollers that are used in these devices are driven to rotate by driving source and gear (not shown).

Furthermore, in the image forming apparatus 1300, a paper cassette 1306 which accommodates the record medium 1305 such as paper in an accumulated state is mounted on a low position; and a hopping roller 1307 is furnished over the paper cassette 1306 for separating the record medium 1305 one by one so as to convey.

Further, on the downstream side in a conveyance direction of the record medium 1305, registration rollers 1310 and 1311 are arranged for amending skew of the record medium 1305 and conveying the record medium 1305 to the four process units 1301~1304 through nipping and holding the record medium 1305 together with pinching rollers 1308 and 1309. The hopping roller 1307 and the registration rollers 1310 and 1311 are linked to rotate by driving source and gear (not shown).

In each opposite position being opposite to each of the respective photosensitive drums in the four process units 1301~1304, a transferring roller 1312 formed by semiconductor rubber or the like is furnished. Then, in order to make toner on the photosensitive drum adhere to the record medium 1305, a predetermined between the surface of the photosensitive drum and the surface of the transferring roller 1312.

Further, a fixing device 1313 has a heating roller and a backup roller and fixes the toner transferred on the record medium 1305 through pressing and heating. Furthermore, ejecting rollers 1314 and 1315 nip and hold the record medium 1305 outputted from the fixing device 1313 together with pinching rollers 1316 and 1317 in an ejecting section, and convey the record medium 1305 to a record medium stacker 1318. Moreover, the ejecting rollers 1314 and 1315 are linked to rotate by driving source and gear (not shown). Here, as the exposing device 1303c, the LED print head 1200 explained in embodiment 10 is adopted.

Next, operation of the image forming apparatus with the structure stated above is explained.

First, the record medium 1305 accommodated in the paper cassette 1306 and in an accumulated state is separated one by one from most upper position by the hopping roller 1307 so as to convey. Continuously, the record medium 1305 is nipped and is held by the registration rollers 1310 and 1311 and the pinching rollers 1308 and 1309; and is conveyed to the photosensitive drum 1301a of the process unit 1301 and the corresponding transferring roller 1312. Then, the record medium 1305 is nipped and is held by the photosensitive drum 1301a and the corresponding transferring roller 1312; and is conveyed by rotation of the photosensitive drum 1301a while a toner image is transferred onto the record surface of the record medium 1305.

Likewise, the record medium 1305 sequentially passes by the process units 1302~1304. In all passing process, the respective electrostatic latent images formed by the exposing devices 1301c∼1304c are respectively developed by the developing devices 1301d~1304d; and toner images of respective colors are sequentially transferred onto the record surface and are overlapped. After the toner images of respective colors are overlapped on the record surface, the overlapped toner images are fixed by the fixing device 1313. Then, the record medium 1305 is nipped and is held by the ejecting rollers 1314 and 1315 and the pinching rollers 1316 and 1317; and is ejected to the record medium stacker 1318 of the image forming apparatus 1300. According to such a process, an color image is formed on the record medium 1305.

The following is to explain an exposure controlling system in the image forming apparatus 1300 of the present invention.

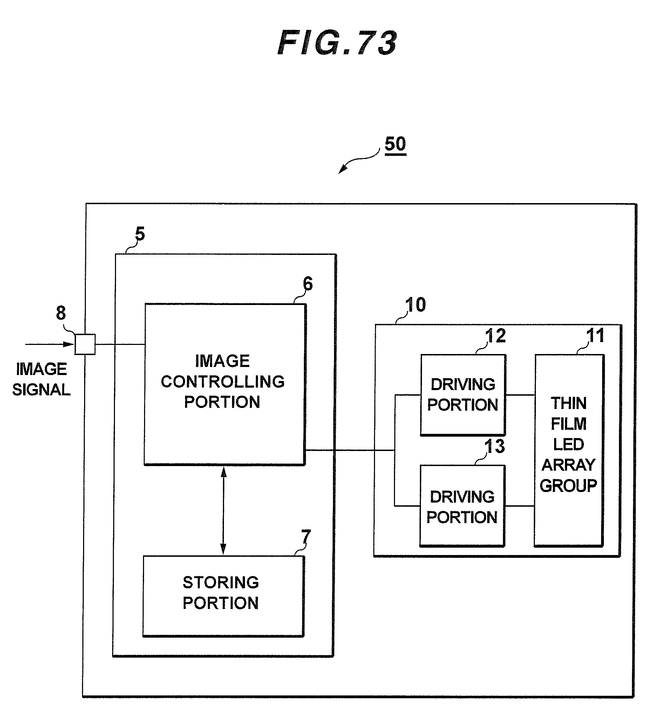

Fig. 73 is a block diagram showing an exposure controlling system in image forming apparatus of the present invention.

As shown by the Fig. 73, an exposure controlling system 50 comprises an image receiving section 8 which is a part to receive image signal from an external apparatus (e.g. animation playing apparatus such as DVD player); a controlling section 5 which is composed of an image controlling portion 6 that converts the image signal received from the image receiving section 8 into a formable form image signal capable of being formed in a LED array panel 10 and outputs the formable form image signal together with control signal; and a storing portion 7 that stores the image signal.

A LED array panel 10 includes a driving portion 12 that uses the image signal converted by the image controlling portion 6 to drive LED serving as a driven element; a driving portion 13 and a thin film LED array group 11 that is formed by arranging plural LED formed in thin film shape.

The driving portion 12 (anode driver) is a part to supply electricity to respective LEDs in the thin film LED array group 11 according to the image signal inputted from the image controlling portion 6, and is constructed by, for example, shift register circuit, latch circuit, constant current circuit, amplifying circuit and the like.

The driving portion 13 (cathode driver) is a part to scan the respective LEDs in the thin film LED array group 11 according to the control signal inputted from the image controlling portion 6, and is constructed by, for example, selecting circuit.

Though such a control system, the image forming apparatus of the present invention is controlled to expose and outputs a print image on the basis of the image signal received from the external apparatus.

As stated above, according to the image forming apparatus, of the embodiment, because adopted the LED print head in embodiment 10 or 11, it is possible to supply an image forming apparatus with high quality and high reliability.

The utilization possibility on industry:

As stated above, the case to apply the present invention to LED element is explained, but the present invention also can be applied to various semiconductor device which bonds semiconductor thin film on substrate.

That is, the present invention is not limited to the foregoing embodiments but many modifications and variations are possible within the spirit and scope of the appended claims of the invention.

Several embodiments may be combined with each other. In summary, an embodiment of the invention can be described as follows:

A semiconductor device is supplied which is able to efficiently liberate heat produced by semiconductor element toward external, prevent temperature rise, improve operation characteristic and maintain stable operation. The semiconductor device comprises a substrate and a semiconductor thin film layer which is accumulated on the substrate and contains semiconductor element, the substrate is a metal substrate, between the metal substrate and the semiconductor thin film layer, a diamond-like carbon layer with high heat conductivity and good insulativity is furnished as a surface coating layer.

## Claims

1. A semiconductor device, comprising:
a substrate;
a semiconductor thin film layer that is accumulated on the substrate and contains semiconductor element; and
a diamond-like carbon layer that is furnished between the substrate and the semiconductor thin film layer.

2. The semiconductor device according to claim 1, further comprising:
a metal layer,
wherein the substrate is made from metal material, and the metal layer is furnished between the substrate and the diamond-like carbon layer.

3. The semiconductor device according to claim 2,
wherein the metal layer has a reflectance being 50% or over with respect to at least one light with a wavelength band within 400nm~1500nm.

4. The semiconductor device according to any of the preceding claims,
wherein an average roughness of a most upper surface of the diamond-like carbon layer is 5nm or below.

5. The semiconductor device according to any of the preceding claims,
wherein a thickness of the diamond-like carbon layer is 1µm or below.

6. The semiconductor device according to any of the preceding claims,
wherein the semiconductor thin film layer and the diamond-like carbon layer are directly bonded.

7. The semiconductor device according to any of the preceding claims,
wherein the semiconductor thin film layer is made from inorganic semiconductor material.

8. The semiconductor device according to claim 7,
wherein the semiconductor thin film layer contains a light emitting element.

9. The semiconductor device according to claim 8,
wherein the light emitting element is a light emitting diode.

10. The semiconductor device according to claim 9,
wherein plural light emitting diodes are furnished on the substrate.

11. The semiconductor device according to claim 10,
wherein the plural light emitting diodes are arranged in one-dimension so as to form a light emitting diode array.

12. The semiconductor device according to claim 10,
wherein the plural light emitting diodes are arranged in two-dimension so as to form a light emitting diode array.

13. The semiconductor device according to any of the preceding claims, further comprising:
a driving circuit to drive the semiconductor element.

14. The semiconductor device according to any of the preceding claims,
wherein the substrate is a freestanding diamond-like carbon substrate.

15. The semiconductor device according to any of the preceding claims,
wherein the substrate is a freestanding SiC.

16. A LED head, comprising:
a semiconductor device,
wherein the semiconductor device includes:
a substrate;
a semiconductor thin film layer that is accumulated on the substrate and contains semiconductor element; and
a diamond-like carbon layer that is furnished between the substrate and the semiconductor thin film layer.

17. An image forming apparatus comprising:
a LED head,
wherein the LED head comprises a semiconductor device,
wherein the semiconductor device includes:
a substrate;
a semiconductor thin film layer that is accumulated on the substrate and contains semiconductor element; and
a diamond-like carbon layer that is furnished between the substrate and the semiconductor thin film layer.
